(19) Europäisches Patentamt
European Patent Office
Office européen des brevets

(11) EP 4 779 333 A1

(12) **EUROPEAN PATENT APPLICATION**
published in accordance with Art. 153(4) EPC

(43) Date of publication:
22.07.2026 Bulletin 2026/30

(21) Application number: 24869945.6

(22) Date of filing: 02.07.2024

(51) International Patent Classification (IPC):
*G01R 31/34* (2020.01)

(52) Cooperative Patent Classification (CPC):
G01R 31/34

(86) International application number:
PCT/CN2024/103164

(87) International publication number:
WO 2025/066388 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.09.2023 CN 202311279483

(71) Applicant: HUAWEI TECHNOLOGIES CO., LTD.
Shenzhen 518129 (CN)

(72) Inventors:
• YAN, Chang
Shenzhen, Guangdong 518129 (CN)
• WANG, Zhengang
Shenzhen, Guangdong 518129 (CN)
• LIANG, Kaixuan
Shenzhen, Guangdong 518129 (CN)

(74) Representative: Thun, Clemens
Mitscherlich PartmbB
Karlstraße 7
80333 München (DE)

(54) **HEALTH LEVEL ASSESSMENT METHOD, STORAGE MEDIUM, AND ELECTRONIC DEVICE**

(57) The present invention relates to the field of assessment technologies, and in particular, to a health state assessment method, a storage medium, and an electronic device. In the method, speed characteristic parameters that can directly reflect a speed status of a motor are used as comparison parameters for assessing a health status of the motor. Specifically, the speed characteristic parameters may be obtained based on data acquired in a duration in which detection needs to be performed; and the speed characteristic parameters are compared with standard speed characteristic parameters in a healthy operational state that are used as a benchmark, to obtain differences between distribution patterns of the two, thereby obtaining a real-time health status of the motor in the duration in which detection needs to be performed. Based on the method, a real-time health status of the motor can be accurately detected.

S310: Obtain a training dataset and a test dataset for health state assessment of an asynchronous motor

S320: Separately calculate characteristic parameters corresponding to the training dataset and characteristic parameters corresponding to the test dataset

S330: Calculate a health state corresponding to the test dataset, based on the characteristic parameters corresponding to the training dataset and the characteristic parameters corresponding to the test dataset

S340: Archive the characteristic parameters corresponding to the training dataset, the characteristic parameters corresponding to the test dataset, and the health state

FIG. 3

**Description**

This application claims priority to Chinese Patent Application No. 202311279483.9, filed with the China National Intellectual Property Administration on September 27, 2023 and entitled "HEALTH STATE ASSESSMENT METHOD, STORAGE MEDIUM, AND ELECTRONIC DEVICE", which is incorporated herein by reference in its entirety.

**TECHNICAL FIELD**

The present invention relates to the field of assessment technologies, and in particular, to a health state assessment method, a storage medium, and an electronic device.

**BACKGROUND**

Asynchronous motors are the power source of electronic or mechanical devices, widely used in various mechanical devices including mining machinery, new energy vehicles, steel mill machinery, chemical pump groups, and the like, to provide power for driving the devices to operate properly. In actual applications, an asynchronous motor inevitably experiences degradation over time, such as electrical faults like inter-turn short circuits, current imbalance, and winding open circuit, or mechanical faults such as air gap eccentricity and bearing failures. The severity of the faults will affect the normal operation of the asynchronous motor to varying degrees. Therefore, the health status of asynchronous motors is closely related to the efficiency and safety of industrial production.

However, the current methods for detecting whether a fault occurs in an asynchronous motor are usually not accurate.

**SUMMARY**

Embodiments of the present invention provide a health state assessment method, a storage medium, and an electronic device, to obtain a relatively accurate difference between a real-time operational state and a healthy operational state of a motor.

According to a first aspect, an embodiment of the present invention provides a health state assessment method. In this method, based on data acquired by a motor in a first duration (that is, a duration in which detection needs to be performed), first speed characteristic parameters (that is, speed characteristic parameters in the duration in which detection needs to be performed) are obtained, and the first speed characteristic parameters in the first duration are compared with standard speed characteristic parameters used as a benchmark, to obtain differences between the two, thereby obtaining a health status (that is, a health state) of the motor in the first duration.

It can be understood that, regardless of any electrical or mechanical fault in the motor, the health status of the motor can be directly reflected in a speed status of the motor. Therefore, in the health state assessment method, the speed characteristic parameters that can directly reflect the speed status of the motor are used as comparison parameters for assessing the health status of the motor, and a relatively accurate comparison result between a real-time health status and a healthy operational state of the motor can be obtained, even when data available to be used as the benchmark is not comprehensive in terms of fault types or an amount of data of each fault type is insufficient.

In a possible implementation of the first aspect, the first speed characteristic parameters may include an equivalent slip in the first duration, an equivalent speed ratio in the first duration, and an equivalent acceleration ratio in the first duration. That is, the first speed characteristic parameters may include an equivalent slip of the motor in the duration in which detection needs to be performed, an equivalent speed ratio of the motor in the duration in which detection needs to be performed, and an equivalent acceleration ratio of the motor in the duration in which detection needs to be performed. In addition, the standard speed characteristic parameters used as the benchmark may include an equivalent slip in a second duration, an equivalent speed ratio in the second duration, and an equivalent acceleration ratio in the second duration. That is, the standard speed characteristic parameters may include an equivalent slip in any duration when the motor is in the healthy operational state, an equivalent speed ratio in the duration when the motor is in the healthy operational state, and an equivalent acceleration ratio in the duration when the motor is in the healthy operational state.

It can be understood that in a possible implementation, speed characteristic parameters when the motor is in the healthy operational state, for example, in any duration of a warranty period of the motor may be used as the standard speed characteristic parameters. Therefore, the standard speed characteristic parameters may reflect the healthy operational state of the motor. A comparison between the speed characteristic parameters of the motor in the duration in which detection needs to be performed and the standard speed characteristic parameters allows for a relatively accurate difference between the health status of the motor in the duration in which detection needs to be performed and the healthy operational state of the motor.

In a possible implementation of the first aspect, the equivalent slip may be equal to a difference between an actual speed of the motor and a theoretical speed of the motor in a first case (that is, in a case in which the theoretical speed of the motor and the actual speed of the motor are constant values). Similarly, the equivalent speed ratio may be equal to a ratio between the actual speed of the motor and the theoretical speed of the motor when the theoretical speed of the motor and the actual speed of the motor are constant values. The equivalent acceleration ratio may be equal to a ratio between an actual acceleration of the motor and a theoretical acceleration sent by a controller of the motor in a second case (that is, in a case in which neither of the theoretical speed of the motor and the actual speed of the motor is a constant value).

It can be understood that, during the operation of the motor, there may be a case in which the theoretical speed and the actual speed remain unchanged, as well as a case in which the theoretical speed and the actual speed change. In the above-described assessment method, the operation of the motor is subdivided into different cases according to a change status of the speed, to obtain corresponding speed characteristic parameters, thereby improving the overall assessment accuracy.

In a possible implementation of the first aspect, to obtain the health state of the motor in the duration in which detection needs to be performed, distribution differences between the first speed characteristic parameters (that is, the speed characteristic parameters in the duration in which detection needs to be performed) and the standard speed characteristic parameters used as the benchmark in each operating scenario may be first obtained; then data of the speed characteristic parameters in the duration in which detection needs to be performed in each operating scenario within a confidence range (that is, a preset confidence range below), and its distribution proportion in all data of the speed characteristic parameters in the duration in which detection needs to be performed are obtained; and then the health state of the motor in the duration in which detection needs to be performed may be obtained based on the distribution differences and the distribution proportion. Each operating scenario is also a scenario with a same operating condition.

It can be understood that, a difference between a distribution of each speed characteristic parameter (one of the equivalent slip, the equivalent speed ratio, and the equivalent acceleration ratio) in the duration in which detection needs to be performed and a distribution of each of the standard speed characteristic parameters in each operating condition may be obtained based on a distribution difference between each speed characteristic parameter in the two durations in each same operating condition. Then, based on a distribution (that is, a distribution proportion), in each operating condition, of each speed characteristic parameter in the duration in which detection needs to be performed, an overall distribution difference between the speed characteristic parameters in the duration in which detection needs to be performed and the standard speed characteristic parameters, that is, the health state in the duration in which detection needs to be performed, may be obtained.

In the above-described health state assessment method, a difference between overall distribution patterns in the two durations may be obtained by obtaining distribution patterns of the speed characteristic parameters in different operating conditions, and a relatively accurate difference between the health status in the duration in which detection needs to be performed and the healthy operational state corresponding to the standard speed characteristic parameters may be obtained.

In a possible implementation of the first aspect, the same operating condition includes: having a same theoretical speed or a same mean theoretical speed, a same speed level, and a same torque; having a same theoretical speed or a same mean theoretical speed, and a same torque; or having a same speed level and a same torque.

It can be understood that the distribution patterns of the speed characteristic parameters may be obtained based on different division principles, for example, the same operating condition, so that the obtained distribution patterns of the speed characteristic parameters are relatively accurate.

In a possible implementation of the first aspect, the distribution differences between the first speed characteristic parameters (that is, the speed characteristic parameters in the duration in which detection needs to be performed) and the standard speed characteristic parameters (that is, the speed characteristic parameters in any duration when the motor is in a healthy operational state) in each operating scenario may be obtained by using the following method, including: obtaining a distribution center of an equivalent slip in the first duration, a distribution center of an equivalent speed ratio in the first duration, and a distribution center of an equivalent acceleration ratio in the first duration that correspond to the first speed characteristic parameters in each operating scenario; and obtaining a distribution center of an equivalent slip in the second duration, a distribution center of an equivalent speed ratio in the second duration, and a distribution center of an equivalent acceleration ratio in the second duration that correspond to the standard speed characteristic parameters in each operating scenario. A first distance between the distribution center of the equivalent slip in the first duration and the distribution center of the equivalent slip in the second duration in each operating scenario is obtained; a second distance between the distribution center of the equivalent speed ratio in the first duration and the distribution center of the equivalent speed ratio in the second duration in each operating scenario is obtained; and a third distance between the distribution center of the equivalent acceleration ratio in the first duration and the distribution center of the equivalent acceleration ratio in the second duration in each operating scenario is obtained.

It can be understood that, in each same operating scenario, that is, in each same operating condition, the distribution differences between the characteristic parameters may be obtained by obtaining the distances between the distribution centers of the characteristic parameters.

In a possible implementation of the first aspect, the distribution proportions of the data of the first speed characteristic parameters in each operating scenario within the first confidence range (that is, the preset confidence range) in the data of the first speed characteristic parameters in all of the operating scenarios may be obtained by using the following method, including: obtaining a first proportion of a sample quantity, within the first confidence range, of a distance that is from the distribution center of the operating scenario and that is for data of the equivalent slip in the first duration in each operating scenario, in a total sample quantity of the data of the equivalent slip in the first duration in the operating scenario; obtaining a second proportion of a sample quantity, within the first confidence range, of a distance that is from the distribution center of the operating scenario and that is for data of the equivalent speed ratio in the first duration in each operating scenario, in a total sample quantity of the data of the equivalent speed ratio in the first duration in the operating scenario; and obtaining a third proportion of a sample quantity, within the first confidence range, of a distance that is from the distribution center of the operating scenario and that is for data of the equivalent acceleration ratio in the first duration in each operating scenario, in a total sample quantity of the data of the equivalent acceleration ratio in the first duration in the operating scenario.

It can be understood that the distribution patterns of the characteristic parameters in each operating scenario (each operating condition) may be obtained by setting a confidence range.

In a possible implementation of the first aspect, the health state of the motor in the first duration may be obtained based on the distribution differences between the first speed characteristic parameters (that is, the speed characteristic parameters in the duration in which detection needs to be performed) and the standard speed characteristic parameters (that is, the speed characteristic parameters in any duration when the motor is in a healthy operational state) and the distribution proportion of the data of the speed characteristic parameters in the duration in which detection needs to be performed in each operating scenario in all the data of the speed characteristic parameters in the duration in which detection needs to be performed by using the following method, including: obtaining, based on the first distance and the first proportion in each operating scenario, a first statistical difference between the equivalent slip in the first duration and the equivalent slip in the second duration in all of the operating scenarios; obtaining, based on the second distance and the second proportion in each operating scenario, a second statistical difference between the equivalent speed ratio in the first duration and the equivalent speed ratio in the second duration in all of the operating scenarios; obtaining, based on the third distance and the third proportion in each operating scenario, a third statistical difference between the equivalent acceleration ratio in the first duration and the equivalent acceleration ratio in the second duration in all of the operating scenarios; and obtaining the health state of the motor in the first duration based on the first statistical difference, the second statistical difference, the third statistical difference, and weight coefficients respectively corresponding to the equivalent slip, the equivalent speed ratio, and the equivalent acceleration ratio.

It can be understood that the health state of the motor in the duration in which detection needs to be performed may be obtained by summarizing the distribution differences between the characteristic parameters in the two durations.

In a possible implementation of the first aspect, the first confidence range includes any one of $[-3\sigma, 3\sigma]$, $[-2\sigma, 2\sigma]$, or $[-\sigma, \sigma]$, where $\sigma$ is a standard deviation of the parameters of the first speed characteristic parameters. For example, $\sigma$ is a standard deviation of the equivalent slip, the equivalent speed ratio, and the equivalent acceleration ratio of the first speed characteristic parameters. It can be understood that the first confidence range, that is, the preset confidence range, may be adjusted according to specific requirements, for example, according to the accuracy of a desired assessment result, thereby obtaining a more accurate health state assessment result.

According to a second aspect, an embodiment of the present invention provides a health state assessment apparatus. The apparatus includes one or more processors and one or more memories. The one or more memories are coupled to the one or more processors. The one or more memories are configured to store computer program code. The computer program code includes computer instructions that, when executed by the one or more processors, cause the apparatus to perform the health state assessment method according to any one of the first aspect or the possible implementations of the first aspect.

According to a third aspect, an embodiment of the present invention provides a chip. The chip includes a processor. The processor executes computer instructions stored in a computer storage medium, to cause an electronic device to implement the health state assessment method according to any one of the possible implementations of the first aspect.

According to a fourth aspect, an embodiment of the present invention provides a readable storage medium. The readable storage medium stores instructions that, when executed on an electronic device, cause the electronic device to implement the health state assessment method according to any one of the possible implementations of the first aspect.

According to a fifth aspect, an embodiment of the present invention provides an electronic device. The electronic device includes: a memory, configured to store instructions executable by one or more processors of the electronic device; and a processor, which is one of the processors of the electronic device and is configured to execute the instructions stored in the memory, to implement the health state assessment method according to any one of the possible implementations of the first aspect.

According to a sixth aspect, an embodiment of the present invention provides a program product. The program product includes instructions that, when executed by an electronic device, cause the electronic device to implement the health state assessment method according to any one of the possible implementations of the first aspect.

**BRIEF DESCRIPTION OF DRAWINGS**

FIG. 1A is a schematic flowchart of a method for detecting whether an electrical fault occurs in a motor by using a fault diagnosis model according to some embodiments of the present invention;
FIG. 1B is a schematic flowchart of a method for detecting mechanical faults in a motor by using a fault feature library matching approach according to some embodiments of the present invention;
FIG. 2 is a diagram of software modules of a health state assessment system according to some embodiments of the present invention;
FIG. 3 is a schematic flowchart of a health state assessment method according to some embodiments of the present invention;
FIG. 4 is a schematic flowchart of another health state assessment method according to some embodiments of the present invention;
FIG. 5A is a time-domain diagram of a set of current signals according to some embodiments of the present invention;
FIG. 5B is a time-frequency analysis diagram of a set of current signals according to some embodiments of the present invention;
FIG. 5C is a spectrum diagram of a set of current signals according to some embodiments of the present invention;
FIG. 5D is a time-domain diagram of a set of vibration signals according to some embodiments of the present invention;
FIG. 5E is a spectrum diagram of a set of vibration signals according to some embodiments of the present invention;
FIG. 5F is a diagram of comparison between theoretical speeds and actual speeds of a set of asynchronous motors according to some embodiments of the present invention;
FIG. 5G is a time-domain diagram of another set of current signals according to some embodiments of the present invention;
FIG. 5H is a time-frequency diagram of another set of asynchronous motors according to some embodiments of the present invention;
FIG. 5I is a time-domain diagram of another set of vibration signals according to some embodiments of the present invention;
FIG. 5J is a time-frequency diagram of another set of asynchronous motors according to some embodiments of the present invention; and
FIG. 6 is a diagram of a hardware structure of an electronic device according to some embodiments of the present invention.

**DESCRIPTION OF EMBODIMENTS**

The technical solutions according to embodiments of this application are clearly and completely described in the following with reference to the accompanying drawings.
Illustrative embodiments of the present invention include but are not limited to a health state assessment method, a storage medium, and an electronic device.
First, terms used in this application are explained below.

(1) Asynchronous motor: also known as an induction motor, which is an AC motor that converts electrical energy into mechanical energy by producing electromagnetic torque through the interaction between a rotating magnetic field in the air gap and an induced current in the rotor windings.

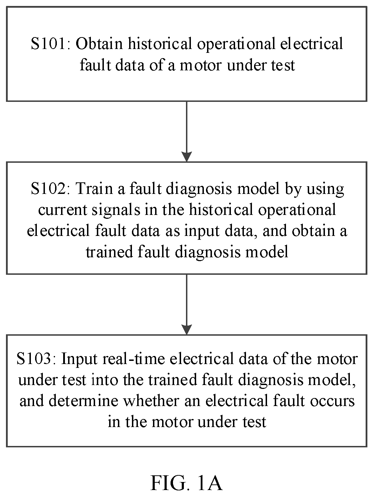

The technical solutions of the present invention are described below with reference to FIG. 1A to FIG. 6.
As described in the background, some of the current methods for detecting whether a fault occurs in an asynchronous motor are usually not accurate.
For example, in some detection methods, a fault diagnosis model is used to detect whether a fault occurs in an asynchronous motor. FIG. 1A shows a method for detecting whether an electrical fault occurs in a motor by using a fault diagnosis model. As shown in FIG. 1A, the detection method includes the following steps.
S101: Obtain historical operational electrical fault data of a motor under test.
S102: Train a fault diagnosis model by using current signals in the historical operational electrical fault data as input data and the presence of electrical faults in the motor under test as output data, and obtain a trained fault diagnosis model.

It can be understood that, when an electrical fault occurs in the asynchronous motor, the asynchronous motor has abnormal characteristics, including a current imbalance, a voltage imbalance, a noticeable increase in a negative-sequence impedance of the motor, and the like. Therefore, the current signals, acquired by a current sensor installed on the motor under test, in the historical operational electrical fault data may be obtained and used as the input data; a reference value for determining that an electrical fault occurs in the motor under test is set to 1, and a reference value for determining that no electrical fault occurs in the motor under test is set to 0, thereby training the fault diagnosis model. The fault diagnosis model may include a convolutional neural network model, a random forest fault diagnosis model, or the like.

S103: Input real-time electrical data of the motor under test into the trained fault diagnosis model, and determine whether an electrical fault occurs in the motor under test.

It can be understood that, after the real-time electrical data of the motor is obtained, current signals in the real-time electrical data may be input into the trained fault diagnosis model, and then whether an electrical fault occurs in the motor under test is determined based on an output result of the fault diagnosis model.

It can be understood that, because the historical operational electrical fault data corresponds only to electrical faults, if a fault diagnosis model is to be used to detect whether a mechanical fault occurs in the motor, the fault diagnosis model may be trained on historical operational mechanical fault data of the motor.

It can be understood that the accuracy of the method for detecting whether an electrical or mechanical fault occurs in the asynchronous motor based on the fault diagnosis model depends on whether operating conditions and application scenarios covered by a training dataset are comprehensive, whether an amount of training data in each operating condition and application scenario is sufficient, and the like. For example, whether the historical operational electrical fault data used for training the fault diagnosis model includes sufficient historical operational electrical fault data in different torque cases, and whether the historical operational electrical fault data corresponds to a same application scenario. The application scenario may include coal mining, road driving, or another scenario.

Therefore, if the historical operational electrical fault data or historical operational vibration fault data used for training the fault diagnosis model does not cover comprehensive operating conditions and application scenarios, or an amount of training data in any operating condition and application scenario is insufficient, or the like, the accuracy of a detection result obtained by using the method for detecting whether an electrical or mechanical fault occurs in the asynchronous motor based on the fault diagnosis model is relatively low.

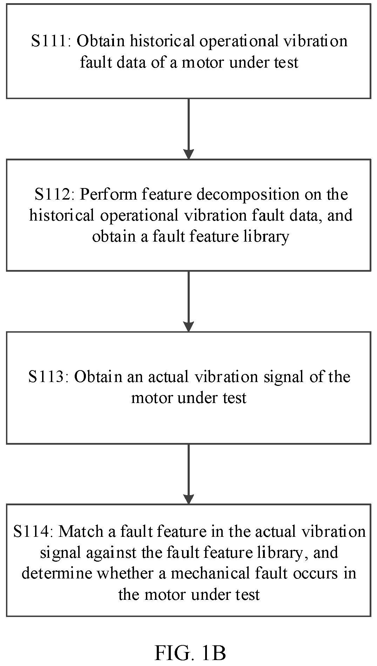

In some other detection methods, a fault feature library matching approach is used to detect whether a fault occurs in an asynchronous motor. FIG. 1B shows a method for detecting mechanical faults in a motor by using a fault feature library matching approach. As shown in FIG. 1B, the detection method includes the following steps.

S111: Obtain historical operational vibration fault data of a motor under test.

S112: Perform feature decomposition on vibration signals in the historical operational vibration fault data, and obtain a fault feature library.

It can be understood that the feature decomposition may be performed on the historical operational vibration fault data, and the fault feature library is obtained based on fault features obtained through decomposition, for example, an amplitude residual and vibration intensity of the vibration signals.

S113: Obtain an actual vibration signal of the motor under test.

S114: Match a fault feature in the actual vibration signal against the fault feature library, and determine whether a mechanical fault occurs in the motor under test.

It can be understood that feature decomposition may be performed on the actual vibration signal, to obtain an amplitude residual, vibration intensity, and the like of the actual vibration signal. Then, the amplitude residual, vibration intensity, and the like of the actual vibration signal are matched against the fault feature in the fault feature library, and whether a mechanical fault occurs in the motor under test is determined based on a matching result.

It can be understood that, because the historical operational mechanical fault data corresponds only to mechanical faults, if a fault feature library matching approach is to be used to detect whether an electrical fault occurs in the asynchronous motor, a fault feature library needs to be re-established, for example, for current signals based on historical operational electrical fault data of the motor.

It can be understood that the accuracy of the method for detecting whether a mechanical or electrical fault occurs in the asynchronous motor based on the fault feature library depends on whether fault feature extraction is accurate, whether operating conditions and application scenarios covered by the historical operational electrical fault data or historical operational vibration fault data are comprehensive, whether an amount of data in each operating condition and application scenario is sufficient, whether a sufficient number of types of fault features are included, and the like.

For example, if the motor serves in a complex environment, when a mechanical fault such as poor lubrication occurs in the motor, the strength of a vibration signal may not change significantly, and it is difficult to extract the strength of the vibration signal, that is, a fault feature of the vibration signal. Alternatively, due to the limited industrial adoption of three-phase current and voltage sensors, it is difficult to obtain all the three phases of voltage and current data, which results in fault features extracted from single-phase current and voltage data being not comprehensive. Alternatively, when an increased internal resistance or another abnormality occurs in the motor, there may be no noticeable abnormality in the current signal and voltage signal, and it is difficult to extract fault features of the current signal and voltage signal. Then, the accuracy of a detection result obtained by using the method for detecting whether an electrical or mechanical fault occurs in the asynchronous motor based on the fault feature library is relatively low.

In addition, if the historical operational vibration fault data or historical operational electrical fault data used for establishing the fault feature library does not cover comprehensive operating conditions and application scenarios, or an amount of data in any operating condition and application scenario is insufficient, or a number of types of fault features of data in any operating condition and application scenario is insufficient, the accuracy of a detection result obtained by using the method for detecting whether an electrical or mechanical fault occurs in the asynchronous motor based on the fault feature library is relatively low.

In view of this, the present invention provides a motor health state assessment method. In this method, speed characteristic parameters (hereinafter referred to as characteristic parameters) of a training dataset (that is, data acquired by an asynchronous motor in a healthy operational state, for example, data acquired in a warranty duration of the asynchronous motor) and a test dataset (that is, data acquired in a duration in which detection needs to be performed for the asynchronous motor) corresponding to the motor in each operating scenario may be separately obtained. The characteristic parameters are used to represent a speed status of the asynchronous motor, including an equivalent slip, an equivalent speed ratio, and an equivalent acceleration ratio. Then, the characteristic parameters of the training dataset and the test dataset in each operating scenario (that is, each distribution area mentioned later) are compared, to obtain distribution differences between distribution patterns of the characteristic parameters of the training dataset and the test dataset in each operating scenario. Then, a health condition of the motor may be determined based on the distribution differences between the distribution patterns of the characteristic parameters of the training dataset and the test dataset in each operating scenario. For example, based on the distribution differences between the distribution patterns of the characteristic parameters of the training dataset and the test dataset in each operating scenario, a distribution proportion of data of the characteristic parameters of the training dataset in the operating scenario within a preset confidence range in data of the characteristic parameters of the entire training dataset, a distribution proportion of data of the characteristic parameters of the test dataset in the operating scenario within the preset confidence range in data of the characteristic parameters of the entire test dataset, and a weight of each characteristic parameter, the health condition of the motor, that is, a specific numerical value or the like of a health state of the asynchronous motor corresponding to the test dataset, may be obtained.

It can be understood that, regardless of any type of fault (for example, any of electrical faults or any of mechanical faults) in the asynchronous motor, a health status of the asynchronous motor is directly reflected in the speed status of the asynchronous motor, for example, in the equivalent slip, the equivalent speed ratio, and the equivalent acceleration ratio of the characteristic parameters. Therefore, a comparison between the characteristic parameters of the asynchronous motor allows for a relatively accurate health state of the asynchronous motor, that is, a relatively accurate comparison result between a real-time health status and the healthy operational state of the asynchronous motor, even when data used as a benchmark (that is, the training dataset) is not comprehensive in terms of fault types or an amount of data of each fault type is insufficient.

It can be understood that, each operating scenario of the asynchronous motor has a same theoretical speed or a same mean theoretical speed, a same speed level, and a same torque; or each operating scenario has a same theoretical speed or a same mean theoretical speed, and a same torque; or each operating scenario has a same speed level and a same torque. It can be understood that a division principle of operating scenarios, that is, distribution areas of the characteristic parameters, is based on a same operating condition or the like, so that each characteristic parameter in the training dataset can be compared with a corresponding characteristic parameter in the test dataset in the same operating scenario.

It can be understood that the equivalent slip of the asynchronous motor is equal to a difference between an actual speed of the asynchronous motor and a theoretical speed sent by a controller of the asynchronous motor in a first case. The equivalent speed ratio is equal to a ratio between the actual speed of the asynchronous motor and the theoretical speed sent by the controller of the asynchronous motor in the first case. The equivalent acceleration ratio is equal to a ratio between an actual acceleration of the asynchronous motor and a theoretical acceleration sent by the controller of the asynchronous motor in a second case. In the first case, the asynchronous motor is in a steady state, and the theoretical speed and the actual speed of the asynchronous motor are constant values. In the second case, the asynchronous motor is in a non-steady state, and neither of the theoretical speed and the actual speed of the asynchronous motor is a constant value.

In a possible implementation, a method for obtaining the health state of the asynchronous motor corresponding to the test dataset may include the following: First, three characteristic parameters of the training dataset, including data of the equivalent slip, the equivalent speed ratio, and the equivalent acceleration ratio, and three characteristic parameters of the test dataset, including data of the equivalent slip, the equivalent speed ratio, and the equivalent acceleration ratio, are separately obtained. Then, in each operating scenario, distribution differences between distribution patterns of the three characteristic parameters of the training dataset and the test dataset are obtained, for example, a difference between the equivalent slip of the training dataset and the equivalent slip of the test dataset in each operating scenario, a difference between the equivalent speed ratio of the training dataset and the equivalent speed ratio of the test dataset in each operating scenario, and a difference between the equivalent acceleration ratio of the training dataset and the equivalent speed ratio of the test dataset in each operating scenario. Then, a distribution proportion of a sample quantity of data of the characteristic parameters of the training dataset in each operating scenario within the preset confidence range, in a total sample quantity of data of the characteristic parameters of the entire training dataset, and a distribution proportion of data of the characteristic parameters of the test dataset in each operating scenario within the preset confidence range in data of the characteristic parameters of the entire test dataset may be calculated. Then, a statistical difference between equivalent slips of the training dataset and the test dataset in all of the operating scenarios, a statistical difference between equivalent speed ratios of the training dataset and the test dataset in all of the operating scenarios, and a statistical difference between equivalent acceleration ratios of the training dataset and the test dataset in all of the operating scenarios are obtained based on the differences of the three characteristic parameters between the training dataset and the test dataset in each operating scenario, the distribution proportion of the data of the characteristic parameters of the training dataset in each operating scenario within the preset confidence range in the data of the entire training dataset, and the distribution proportion of the data of the characteristic parameters of the test dataset in each operating scenario within the preset confidence range in the data of the entire test dataset. Finally, the specific numerical value of the health state of the asynchronous motor corresponding to the test dataset may be obtained based on a weight of each characteristic parameter, the statistical difference between the equivalent slips of the training dataset and the test dataset in all of the operating scenarios, the statistical difference between the equivalent speed ratios of the training dataset and the test dataset in all of the operating scenarios, and the statistical difference between the equivalent acceleration ratios of the training dataset and the test dataset in all of the operating scenarios.

It can be understood that the data in the training dataset may reflect a working status of the asynchronous motor in the healthy operational state. Therefore, a comparison between the characteristic parameters corresponding to the test dataset and the characteristic parameters corresponding to the test dataset allows for a comparison result between the working status corresponding to the data in the test dataset and the healthy operational state of the asynchronous motor.

It can be understood that, in some embodiments, if a fault diagnosis model is to be used to detect whether an electrical or mechanical fault occurs in the asynchronous motor, the fault diagnosis model needs to be trained on both historical operational electrical fault data of the motor and historical operational mechanical fault data of the motor. That is, the same fault diagnosis model cannot be used to detect both electrical and mechanical faults. In addition, the accuracy of the method for detecting whether an electrical or mechanical fault occurs in the asynchronous motor based on the fault diagnosis model depends on whether operating conditions and application scenarios covered by a training dataset are comprehensive, whether an amount of training data in each operating condition and application scenario is sufficient, and the like.

It can be understood that, in some other embodiments, if a fault feature library matching approach is to be used to detect whether an electrical or mechanical fault occurs in the asynchronous motor, a fault feature library needs to be established, for example, not only for current signals based on historical operational electrical fault data of the motor, but also for vibration signals based on historical operational mechanical fault data of the motor. That is, the same fault feature library cannot be used to detect both electrical and mechanical faults. In addition, the accuracy of the method for detecting whether a mechanical or electrical fault occurs in the asynchronous motor based on the fault feature library depends on whether fault feature extraction is accurate, whether operating conditions and application scenarios covered by the historical operational electrical fault data or historical operational vibration fault data are comprehensive, whether an amount of data in each operating condition and application scenario is sufficient, whether a sufficient number of types of fault features are included, and the like.

It can be understood that any type of fault of the asynchronous motor, including electrical and mechanical faults and other possible faults, may directly cause the speed status of the asynchronous motor to be different from the speed status of the asynchronous motor in the healthy operational state. That is, when a fault occurs, there are distribution differences between the characteristic parameters representing the speed status of the asynchronous motor, including the equivalent slip, the equivalent speed ratio, and the equivalent acceleration ratio, and the characteristic parameters representing the speed status of the asynchronous motor in the healthy operational state, including the equivalent slip, the equivalent speed ratio, and the equivalent acceleration ratio, thereby affecting normal use of the asynchronous motor. Therefore, according to the above-described motor health state assessment method based on characteristic parameters, a relatively accurate detection result can be obtained, without extracting all types of fault features or considering whether the data used as the benchmark includes a sufficient number of types of fault features. A comparison between the characteristic parameters of the asynchronous motor allows for a relatively accurate difference between the real-time health status and the healthy operational state of the asynchronous motor, even when the application scenarios are not comprehensive or the amount of data is insufficient.

The above-described health state assessment method allows for a relatively accurate assessment of the difference between the real-time operational state and the healthy operational state of the asynchronous motor by comparing the distribution differences between the characteristic parameters of the speed status of the asynchronous motor in the healthy operational state that correspond to the training dataset with the characteristic parameters of the speed status of the asynchronous motor in the real-time operational state that correspond to the test dataset. In addition, the parameters may further be stored into different archives, which can also provide accurate and rich reference basis for the subsequent life prediction, degradation prediction, and the like of the asynchronous motor.

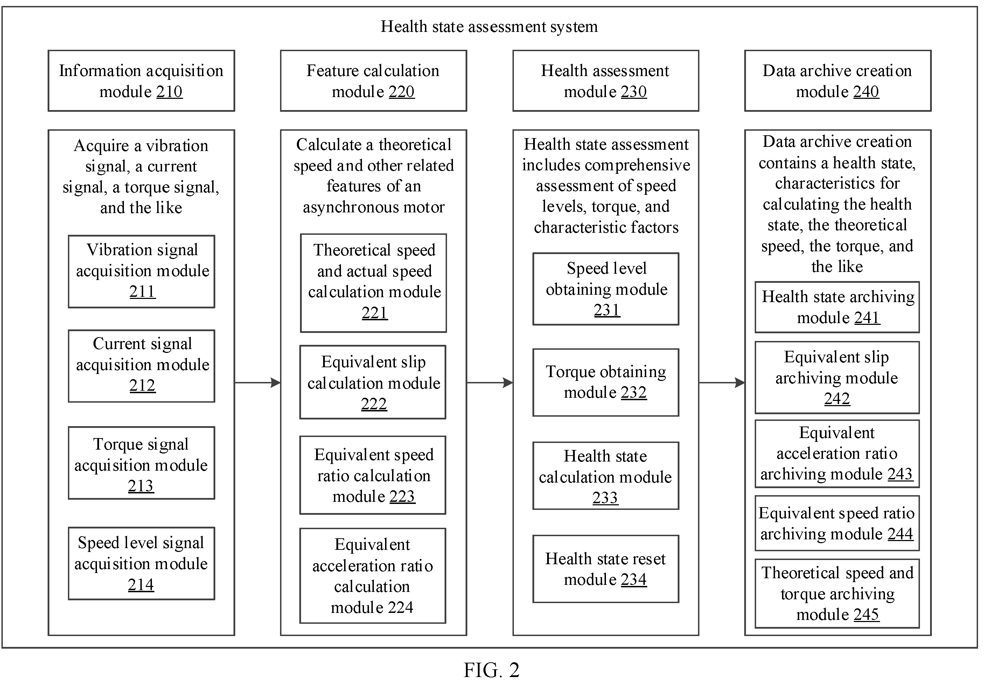

A health state assessment method according to the present invention is described below with reference to FIG. 2, FIG. 3, FIG. 4, FIG. 5A to FIG. 5J, and FIG. 6.

In embodiments of this application, an asynchronous motor is taken as an example for description. Another device having a similar function may also be applicable to the health state assessment method in this application. The type of a device applicable to the health state assessment method in this application is not specifically limited in embodiments of this application.

FIG. 2 is a diagram of software modules of a health state assessment system used to implement a health state assessment method in this application. As shown in FIG. 2, a health state assessment system may include an information acquisition module 210, a feature calculation module 220, a health assessment module 230, and a data archive creation module 240.

The information acquisition module 210 is configured to acquire a vibration signal, a current signal, a torque signal, and a speed level signal of the asynchronous motor, and send the acquired vibration signal, current signal, torque signal, and speed level signal of the asynchronous motor to the feature calculation module 220. The information acquisition module 210 includes a vibration signal acquisition module 211, a current signal acquisition module 212, a torque signal acquisition module 213, and a speed level signal acquisition module 214. The vibration signal acquisition module 211 is configured to receive a vibration signal of the asynchronous motor that is acquired and sent by a vibration acceleration sensor or a vibration speed sensor. The current signal acquisition module 212 is configured to receive a current signal of the asynchronous motor that is acquired and sent by a current sensor. The torque signal acquisition module 213 is configured to receive a torque signal of the asynchronous motor that is acquired and sent by a torque sensor. The speed level signal acquisition module 214 is configured to receive a speed level signal of the asynchronous motor that is sent by a control system of the asynchronous motor. For example, the speed level signal of the asynchronous motor may include a first speed level, a second speed level, and a third speed level, where the first speed level corresponds to a rated speed of 15 revolutions/second, the second speed level corresponds to a rated speed of 25 revolutions/second, and the third speed level corresponds to a rated speed of 35 revolutions/second. Each speed level corresponds to a different rated speed.

In a possible implementation, the information acquisition module 210 may include only the vibration signal acquisition module 211, the current signal acquisition module 212, and the speed level signal acquisition module 214; or may include only the vibration signal acquisition module 211 and the current signal acquisition module 212. The type and the number of modules in the information acquisition module 210 are not specifically limited in embodiments of this application.

It can be understood that the current sensor, the vibration acceleration sensor, the vibration speed sensor, the torque sensor, and the like may be sensors configured to acquire various types of signals, and may be installed on the asynchronous motor. The types of the sensors used and the installation positions of the sensors are not specifically limited in embodiments of this application.

The feature calculation module 220 is configured to calculate a theoretical speed, an actual speed, an equivalent slip, an equivalent speed ratio, and an equivalent acceleration ratio of the asynchronous motor, and send the obtained torque signal, speed level signal, theoretical speed, actual speed, equivalent slip, equivalent speed ratio, and equivalent acceleration ratio of the asynchronous motor to the health assessment module 230. The equivalent slip of the asynchronous motor is equal to a difference between the actual speed of the asynchronous motor and the theoretical speed sent by a controller of the asynchronous motor. The equivalent speed ratio is equal to a ratio between the actual speed of the asynchronous motor and the theoretical speed sent by the controller of the asynchronous motor. The equivalent acceleration ratio is equal to a ratio between an actual acceleration of the asynchronous motor and a theoretical acceleration sent by the controller of the asynchronous motor. The feature calculation module 220 includes a theoretical speed and actual speed calculation module 221, an equivalent slip calculation module 222, an equivalent speed ratio calculation module 223, and an equivalent acceleration ratio calculation module 224.

The theoretical speed and actual speed calculation module 221 is configured to calculate the actual speed based on the vibration signal of the asynchronous motor obtained by the vibration signal acquisition module 211, and calculate the theoretical speed based on the current signal of the asynchronous motor obtained by the current signal acquisition module 212. The equivalent slip calculation module 222 is configured to calculate the equivalent slip based on the theoretical speed and the actual speed calculated by the theoretical speed and actual speed calculation module 221. The equivalent speed ratio calculation module 223 is configured to calculate the equivalent speed ratio in a first case based on the theoretical speed and the actual speed obtained by the theoretical speed and actual speed calculation module 221.

The equivalent acceleration ratio calculation module 224 is configured to calculate the equivalent acceleration ratio in a second case based on the theoretical speed and the actual speed obtained by the theoretical speed and actual speed calculation module 221. In the first case, the asynchronous motor is in a steady state, and the theoretical speed and the actual speed of the asynchronous motor are constant values. In the second case, the asynchronous motor is in a non-steady state, and neither of the theoretical speed and the actual speed of the asynchronous motor is a constant value.

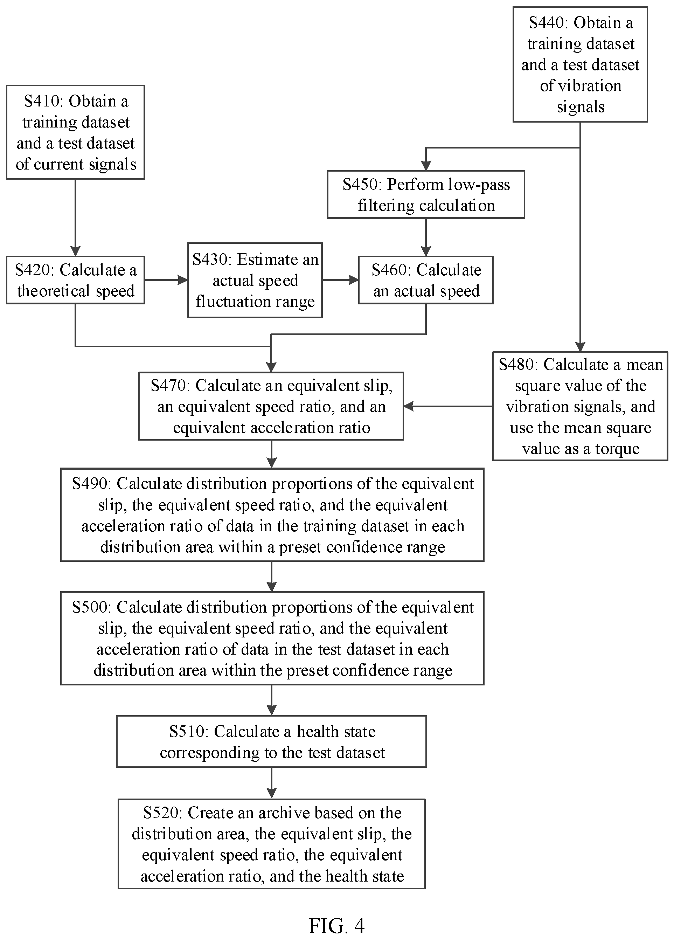

The health assessment module 230 is configured to calculate a health state of the asynchronous motor based on the torque signal, the speed level signal, the theoretical speed, the actual speed, the equivalent slip, the equivalent speed ratio, and the equivalent acceleration ratio of the asynchronous motor that are sent by the feature calculation module 220; and send the speed level, the torque, the health state, the theoretical speed, the equivalent slip, the equivalent speed ratio, and the equivalent acceleration ratio of the asynchronous motor to the data archive creation module 240. The health assessment module 230 includes a speed level obtaining module 231, a torque obtaining module 232, a health state calculation module 233, and a health state reset module 234. The speed level obtaining module 231 is configured to receive the speed level signal of the asynchronous motor that is sent by the feature calculation module 220. The torque obtaining module 232 is configured to receive the torque signal of the asynchronous motor that is sent by the feature calculation module 220. The health state calculation module 233 is configured to calculate the health state of the asynchronous motor based on the torque signal, the speed level signal, the theoretical speed, the actual speed, the equivalent slip, the equivalent speed ratio, and the equivalent acceleration ratio of the asynchronous motor that are sent by the feature calculation module 220. The health state reset module 234 is configured to clear previous health state information before the health state calculation module 233 calculates the current health state. A method for calculating the health state of the asynchronous motor by the health state calculation module 233 is described in detail below with reference to FIG. 4.

The data archive creation module 240 is configured to create an archive based on the speed level, torque, theoretical speed, health state, equivalent slip, equivalent speed ratio, and equivalent acceleration ratio that are sent by the health assessment module 230. The data archive creation module 240 includes a health state archiving module 241, an equivalent slip archiving module 242, an equivalent acceleration ratio archiving module 243, an equivalent speed ratio archiving module 244, and a theoretical speed and torque archiving module 245. The health state archiving module 241 is configured to save the health state data of the asynchronous motor that is sent by the health assessment module 230. The equivalent slip archiving module 242 is configured to save the equivalent slip data of the asynchronous motor that is sent by the health assessment module 230. The equivalent acceleration ratio archiving module 243 is configured to save the equivalent acceleration ratio data of the asynchronous motor that is sent by the health assessment module 230. The equivalent speed ratio archiving module 244 is configured to save the equivalent speed ratio data of the asynchronous motor that is sent by the health assessment module 230. The theoretical speed and torque archiving module 245 is configured to save the theoretical speed and torque data of the asynchronous motor that is sent by the health assessment module 230; or is configured to save the speed level and torque data of the asynchronous motor that is sent by the health assessment module 230. In addition, distribution areas of the data in the health state archiving module 241, the equivalent slip archiving module 242, the equivalent acceleration ratio archiving module 243, and the equivalent speed ratio archiving module 244 correspond to distribution areas of the data in the theoretical speed and torque archiving module 245.

It can be understood that, the health state assessment system may assess the health state of the asynchronous motor based on the acquired vibration signal, current signal, torque signal, and speed level signal of the asynchronous motor, and save an assessment result and various data into different archives, providing relatively accurate data support for life prediction and degradation prediction of the asynchronous motor.

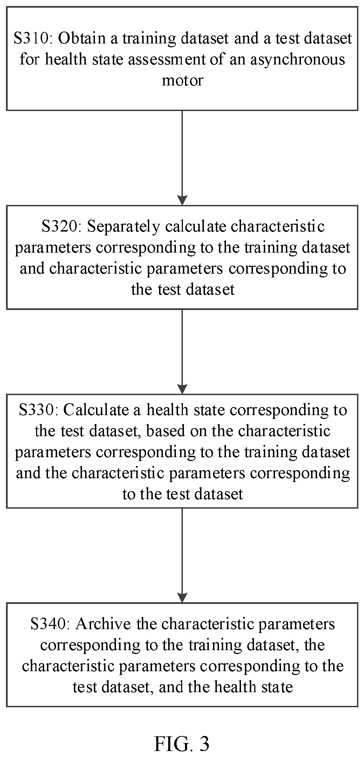

Based on the health state assessment system shown in FIG. 2, a health state assessment method according to the present invention is described below with reference to FIG. 3 and FIG. 4. FIG. 3 is a schematic flowchart of a health state assessment method. As shown in FIG. 3, a health state assessment method may include the following steps.

S310: Obtain a training dataset and a test dataset for health state assessment of an asynchronous motor.

It can be understood that the specific types of signals acquired may be set based on an actual scenario. For example, from the perspective of reducing overall costs and improving assessment efficiency, in a possible implementation, data of current signals and vibration signals of the asynchronous motor may be acquired as the training dataset and the test dataset for health state assessment. Alternatively, in another possible implementation, data of current signals, vibration signals, and speed level signals of the asynchronous motor may be acquired as the training dataset and the test dataset for health state assessment. Alternatively, in another possible implementation, data of current signals, vibration signals, speed level signals, and torque signals of the asynchronous motor may be acquired as the training dataset and the test dataset for health state assessment. In this application, the types of the signals acquired are not specifically limited.

It can be understood that acquisition durations of the training dataset and the test dataset of the current signals may be set according to an actual situation. For example, the acquisition durations may be set according to a period of a healthy operational state of the asynchronous motor, for example, a warranty period of the asynchronous motor. If the warranty period of the asynchronous motor is 12 months, the acquisition duration of the training dataset of the current signals may be set to be within 12 months of normal operation after the asynchronous motor leaves the factory, and the acquisition duration of the test dataset of the current signals may be set to be within the 12th month to the 24th month after the asynchronous motor leaves the factory.

In a possible implementation, the acquisition duration of the training dataset may be greater than or equal to three months, so that sufficient data is provided for assessing the health state of the asynchronous motor, improving the accuracy of the health state of the asynchronous motor. In this application, the acquisition durations of the training dataset and the test dataset of the current signals are not specifically limited.

It can be understood that a current clamp may be added to the asynchronous motor, to acquire single-phase current signals x(t) in a frequency conversion cabinet of the asynchronous motor. In embodiments of this application, the device configured to acquire the current signals of the asynchronous motor is not specifically limited.

For example, 50 sets of current signals may be acquired every 24 hours, each with an acquisition duration of 2 seconds, and an acquisition time interval between every two adjacent sets of current signals is greater than or equal to 20 minutes. It can be understood that the total time for acquiring the current signals, the number of sets of the acquired current signals, the acquisition duration of each set of current signals, and the acquisition time interval between every two adjacent sets of current signals may all be set according to specific scenarios and requirements. In embodiments of this application, the specific numerical values of the aforementioned parameters are not specifically limited.

It can be understood that parameters such as time, frequency, and duration for acquiring vibration signals are respectively the same as those for acquiring the current signals; that is, the vibration signals and the current signals are acquired at the same time by using the same frequency and duration. Acquisition durations of the training dataset and the test dataset of the vibration signals may be set according to actual requirements, corresponding to the case of the current signals.

For example, the acquisition durations may also be set according to the warranty period of the asynchronous motor. If the warranty period of the asynchronous motor is 12 months, the acquisition duration of the training dataset of the vibration signals may be set to be within 12 months of normal operation after the asynchronous motor leaves the factory, and the acquisition duration of the test dataset of the vibration signals may be set to be within the 12th month to the 24th month after the asynchronous motor leaves the factory. In this application, the acquisition durations of the training dataset and the test dataset of the vibration signals are not specifically limited.

It can be understood that a vibration acceleration sensor or a vibration speed sensor may be added to the asynchronous motor, to acquire vibration signals y(t) of the asynchronous motor. For example, 50 sets of vibration signals may be acquired every 24 hours, each with an acquisition duration of 2 seconds, and an acquisition time interval between every two adjacent sets of vibration signals is greater than or equal to 20 minutes. It can be understood that the total time for acquiring the vibration signals, the number of sets of the acquired vibration signals, the acquisition duration of each set of vibration signals, and the acquisition time interval between every two adjacent sets of vibration signals may all be set according to specific scenarios and requirements. In embodiments of this application, the specific numerical values of the aforementioned parameters are not specifically limited.

S320: Separately calculate characteristic parameters corresponding to the training dataset and characteristic parameters corresponding to the test dataset.

In a possible implementation, a theoretical speed and an actual speed of the training dataset of the asynchronous motor may be calculated based on the current signals and the vibration signals of the training dataset of the asynchronous motor, and characteristic parameters such as an equivalent slip, an equivalent speed ratio, and an equivalent acceleration ratio of the training dataset may be further calculated. In addition, a theoretical speed and an actual speed of the test dataset of the asynchronous motor are calculated based on the current signals and the vibration signals of the test dataset of the asynchronous motor, and characteristic parameters such as an equivalent slip, an equivalent speed ratio, and an equivalent acceleration ratio of the training dataset may be further calculated.

For example, in a first case, that is, when the asynchronous motor is in a steady state, and both the theoretical speed and the actual speed of the asynchronous motor are constant values, the equivalent slip and the equivalent speed ratio of the asynchronous motor are calculated. In a second case, that is, when the asynchronous motor is in a non-steady state, and neither of the theoretical speed and the actual speed of the asynchronous motor are constant values, the equivalent acceleration ratio of the asynchronous motor is calculated. The equivalent slip is equal to a difference between the actual speed and the theoretical speed in the first case. The equivalent speed ratio is equal to a ratio between the actual speed and the theoretical speed in the first case. The equivalent acceleration ratio is equal to a ratio between an actual acceleration and a theoretical acceleration in the second case, that is, a ratio between a first-order difference of the actual speed and a first-order difference of the theoretical speed. A specific method for calculating the characteristic parameters corresponding to the training dataset and the characteristic parameters corresponding to the test dataset is described in detail below with reference to FIG. 4.

S330: Calculate a health state corresponding to the test dataset, based on the characteristic parameters corresponding to the training dataset and the characteristic parameters corresponding to the test dataset.

In a possible implementation, distribution differences of the three characteristic parameters between the training dataset and the test dataset in each operating scenario may be calculated, for example, a distribution difference of the equivalent slip, a distribution difference of the equivalent speed ratio, and a distribution difference of the equivalent acceleration ratio. Then, a distribution proportion of data of the characteristic parameters of the training dataset in each operating scenario within a preset confidence range in data of the characteristic parameters of the entire training dataset, and a distribution proportion of data of the characteristic parameters of the test dataset in each operating scenario within the preset confidence range in data of the characteristic parameters of the entire test dataset may be calculated. Then, a statistical difference between the equivalent slip of the training dataset and the equivalent slip of the test dataset in all of the operating scenarios, a statistical difference between the equivalent speed ratio of the training dataset and the equivalent speed ratio of the test dataset in all of the operating scenarios, and a statistical difference between the equivalent acceleration ratio of the training dataset and the equivalent acceleration ratio of the test dataset in all of the operating scenarios may be obtained based on the distribution differences of the three characteristic parameters between the training dataset and the test dataset in each operating scenario, the distribution proportion of the data of the characteristic parameters of the training dataset in each operating scenario within the preset confidence range in the data of the entire training dataset, and the distribution proportion of the data of the characteristic parameters of the test dataset in each operating scenario within the preset confidence range in the data of the entire test dataset. Finally, the health state of the asynchronous motor corresponding to the test dataset may be obtained based on a weight of each characteristic parameter, the statistical difference between the equivalent slip of the training dataset and the equivalent slip of the test dataset in all of the operating scenarios, the statistical difference between the equivalent speed ratio of the training dataset and the equivalent speed ratio of the test dataset in all of the operating scenarios, and the statistical difference between the equivalent acceleration ratio of the training dataset and the equivalent acceleration ratio of the test dataset in all of the operating scenarios.

It can be understood that, each operating scenario of the asynchronous motor has a same theoretical speed or a same mean theoretical speed, a same speed level, and a same torque; or each operating scenario has a same theoretical speed or a same mean theoretical speed, and a same torque; or each operating scenario has a same speed level and a same torque. It can be understood that a division principle of operating scenarios, that is, distribution areas of the characteristic parameters, is based on a same operating condition or the like, so that each characteristic parameter in the training dataset can be compared with a corresponding characteristic parameter in the test dataset in the same operating scenario.

It can be understood that the data in the training dataset may reflect a working status of the asynchronous motor in the healthy operational state. A comparison between the characteristic parameters corresponding to the test dataset and the characteristic parameters corresponding to the training dataset allows for a difference between a working status corresponding to the data in the test dataset and the healthy operational state of the asynchronous motor, and the difference is reflected by the numerical value of the health state. In addition, regardless of any type of fault in the asynchronous motor, the health status of the asynchronous motor is directly reflected in the equivalent slip, the equivalent speed ratio, and the equivalent acceleration ratio of the asynchronous motor. Therefore, the real-time health status of the asynchronous motor can be directly obtained by comparing the characteristic parameters such as the equivalent slip, the equivalent speed ratio, and the equivalent acceleration ratio of the asynchronous motor, thereby improving the accuracy, efficiency, cost-effectiveness, and convenience of assessing the health status of the asynchronous motor.

A specific method for calculating a health state corresponding to the test dataset is described in detail below with reference to FIG. 4.

S340: Archive the characteristic parameters corresponding to the training dataset, the characteristic parameters corresponding to the test dataset, and the health state.

It can be understood that, the characteristic parameters corresponding to the training dataset, the characteristic parameters corresponding to the test dataset, and the health state can be archived, and then relatively accurate data support can be provided for life prediction and degradation prediction of the asynchronous motor.

In the above-described health state assessment method, a comparison between the characteristic parameters of the test dataset and the characteristic parameters of the training dataset of the asynchronous motor allows for a difference between the working status corresponding to the data of the test dataset and the working status corresponding to the data of the training dataset of the asynchronous motor, that is, the healthy operational state of the asynchronous motor, and the difference is intuitively reflected by the numerical value of the health state, to obtain the health state of the test dataset of the asynchronous motor, providing a relatively accurate reference basis for assessing the health status of the asynchronous motor. In addition, the characteristic parameters corresponding to the training dataset, the characteristic parameters corresponding to the test dataset, and the health state are further archived, providing a relatively accurate reference basis for life prediction, degradation prediction, and the like of the asynchronous motor.

In some possible implementations, FIG. 4 is a schematic flowchart of another health state assessment method. As shown in FIG. 4, a health state assessment method includes the following steps.

S410: Obtain a training dataset and a test dataset of current signals.

It can be understood that for the method for obtaining the current signals, refer to step S310 in FIG. 3, and details are not described herein again.

S420: Calculate a theoretical speed.

It can be understood that the theoretical speed of the asynchronous motor for each set of current signals in the training dataset and the test dataset may be calculated based on data in the training dataset and the test dataset of the current signals that are obtained in step S410.

In a possible implementation, in a first case, the asynchronous motor is in a steady state, and the theoretical speed and an actual speed of the asynchronous motor are constant values, or changes in the theoretical speed and the actual speed are both less than a first threshold, for example, 0.1/s. In embodiments of this application, a specific numerical value of the first threshold is not specifically limited.

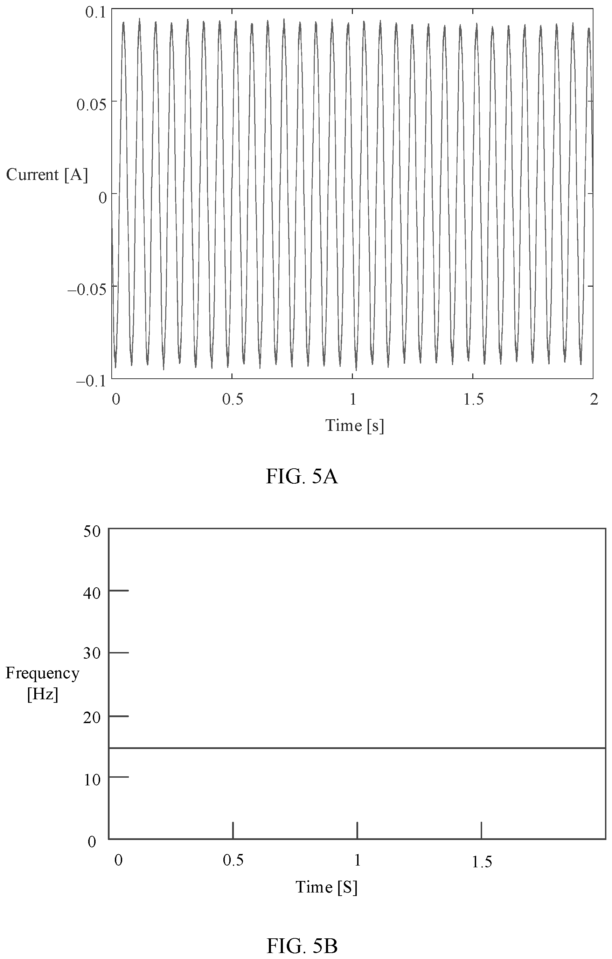

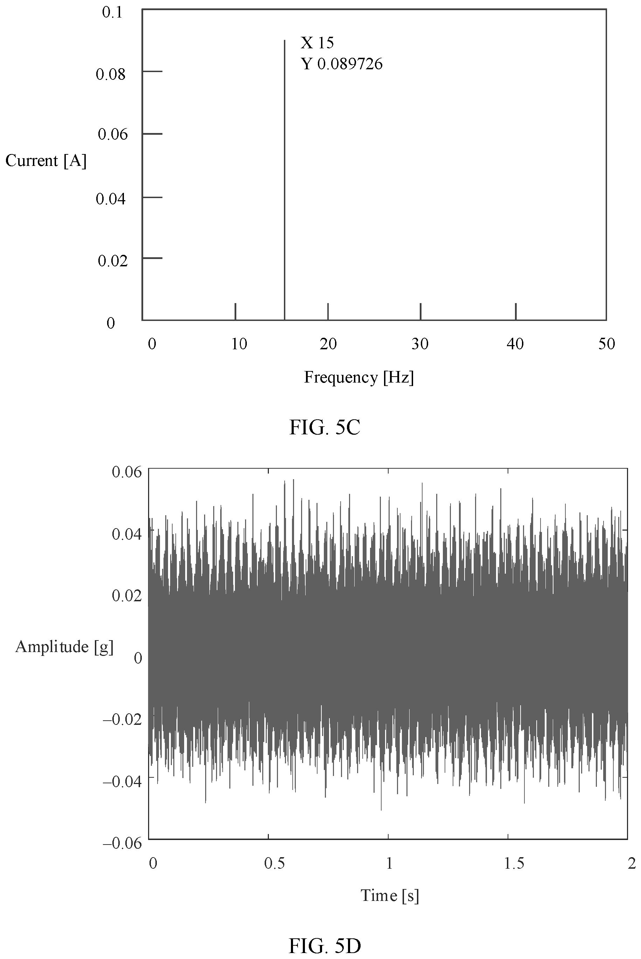

For example, FIG. 5A is a time-domain diagram of a set of current signals, with an acquisition duration of 2 seconds. Based on the time-domain diagram of the current signals shown in FIG. 5A, a time-frequency analysis diagram of the current signals shown in FIG. 5B may be obtained by using a short-time Fourier transform or another method, and a spectrum diagram of the current signals shown in FIG. 5C may be obtained by using a Fourier transform or another method. Therefore, according to the spectrum diagram of the current signals shown in FIG. 5C, the theoretical speed of the asynchronous motor corresponding to the current signals in FIG. 5A may be obtained; that is, the theoretical speed sent by the controller of the asynchronous motor is $v_0$=15.0 Hz.

It can be understood that other method may also be used to calculate the theoretical speed of the asynchronous motor, and theoretical speeds of the asynchronous motor calculated by using different methods may be compared. If the theoretical speeds of the asynchronous motor obtained through calculation based on a plurality of methods are equal, or a difference between the theoretical speeds of the asynchronous motor is less than a preset threshold, a final theoretical speed of the asynchronous motor may be determined. In embodiments of this application, the method for calculating the theoretical speed of the asynchronous motor and the rule for determining the theoretical speed of the asynchronous motor are not specifically limited.

S430: Estimate an actual speed fluctuation range.

It can be understood that a speed fluctuation range corresponding to each set of current signals of the asynchronous motor may be estimated based on the theoretical speed of the asynchronous motor corresponding to each set of current signals and obtained in step S420. For example, if the theoretical speed of the asynchronous motor is $v_0$=15.0 Hz, the speed fluctuation range of the asynchronous motor may be estimated to be $[0, v_0]$. In embodiments of this application, a method for estimating the speed fluctuation range of the asynchronous motor is not specifically limited.

S440: Obtain a training dataset and a test dataset of vibration signals.

It can be understood that for the method for obtaining the vibration signals, refer to step S310 in FIG. 3, and details are not described herein again.

S450: Perform low-pass filtering calculation.

It can be understood that, if the vibration speed sensor is used to obtain the vibration signals in step S440, because a sampling frequency of the vibration speed sensor is a low frequency and a difference between the sampling frequency and the rotation frequency is relatively small, the low-pass filtering calculation in step S450 may be skipped. However, if the vibration acceleration sensor is used to obtain the vibration signal in step S440, because a sampling frequency is relatively high and a difference between the sampling frequency and the rotation frequency is relatively large, a signal obtained by sampling may include a large number of other noise signals. In this case, a low-pass filtering method may be used to remove acquired high-frequency signals, thereby improving the accuracy of the vibration signals in the training dataset and the test dataset.

S460: Calculate the actual speed.

It can be understood that an actual speed for each set of vibration signals in the training dataset and the test dataset may be calculated based on data in the training dataset and the test dataset of the vibration signals that are output in step S440 or step S450.

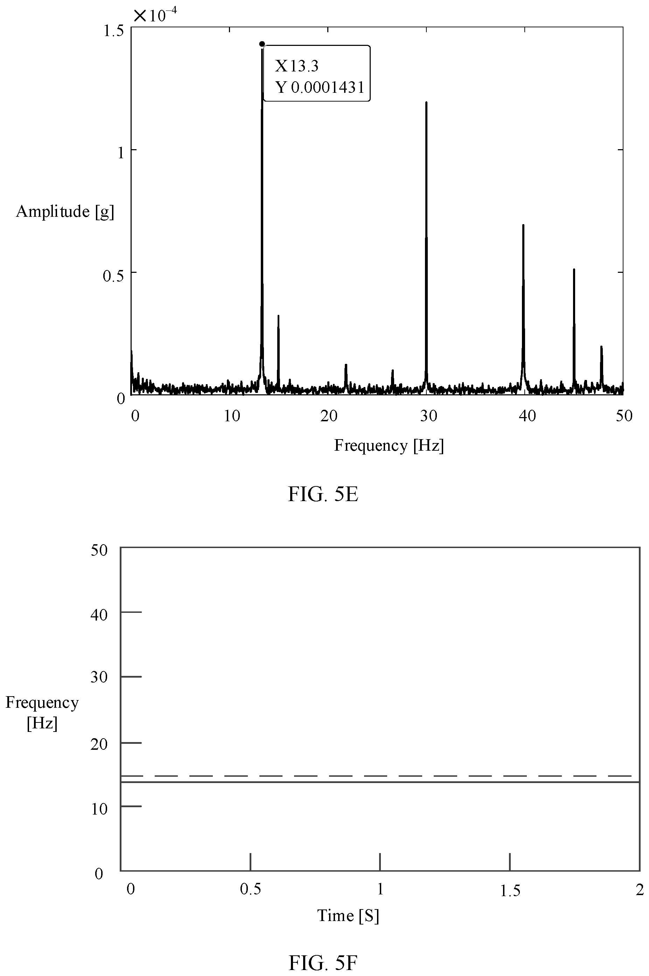

For example, FIG. 5D is a time-domain diagram of a set of vibration signals obtained by using a vibration speed sensor, with an acquisition duration of 2 seconds. Based on the time-domain diagram of the vibration signals shown in FIG. 5D, a spectrum diagram of the vibration signals shown in FIG. 5E may be obtained by using a Fourier transform or another method, and a frequency range of this set of vibration signals is [0, 50] Hz. Based on the spectrum diagram of the vibration signals shown in FIG. 5E, and the actual speed fluctuation range $[0, v_0]$, that is, [0, 15] Hz, of the asynchronous motor in step S420, a maximum may be obtained from the actual speed fluctuation range of the asynchronous motor; that is, the actual speed of the asynchronous motor corresponding to the vibration signals in FIG. 5D is obtained as $v_1$=13.3 Hz. Then, a diagram of comparison between the theoretical speed and the actual speed of the asynchronous motor shown in FIG. 5F may be obtained based on the theoretical speed and the actual speed of the asynchronous motor. It can be understood that the actual speed of the asynchronous motor is less than the theoretical speed.

S470: Calculate an equivalent slip, an equivalent speed ratio, and an equivalent acceleration ratio.

It can be understood that, the equivalent slip, the equivalent speed ratio, and the equivalent acceleration ratio for each set of corresponding current signals and vibration signals in the training dataset and the test dataset may be separately calculated based on the actual speed in step S460 and the theoretical speed in step S420.

In the first case, the asynchronous motor is in a steady state, and the theoretical speed and the actual speed of the asynchronous motor are constant values. The equivalent slip is equal to a difference between the actual speed and the theoretical speed. Then, the equivalent slip corresponding to the theoretical speed $v_0$ is $\varepsilon_v$=1.70 Hz.

The equivalent speed ratio of the asynchronous motor is equal to a ratio between the actual speed of the asynchronous motor and the theoretical speed sent by the controller of the asynchronous motor. Then, the equivalent speed ratio of the asynchronous motor may be obtained as $r_v$=$v_1$/$v_0$=88.67%.

In the second case, the asynchronous motor outputs a non-steady speed; that is, the actual speed of the asynchronous motor changes. For example, a change in the actual speed within a unit of time is greater than or equal to the first threshold.

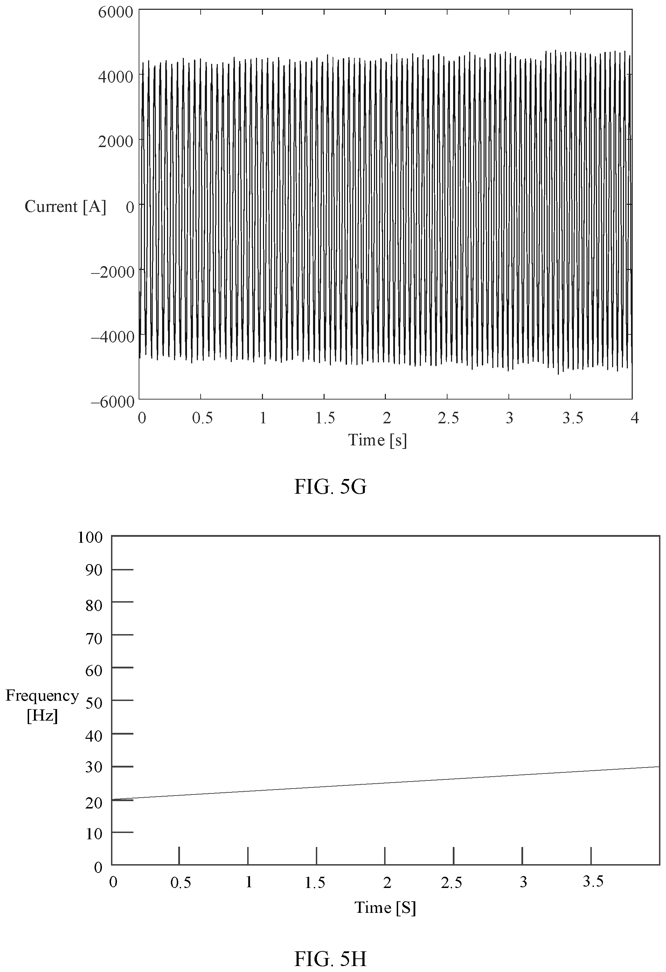

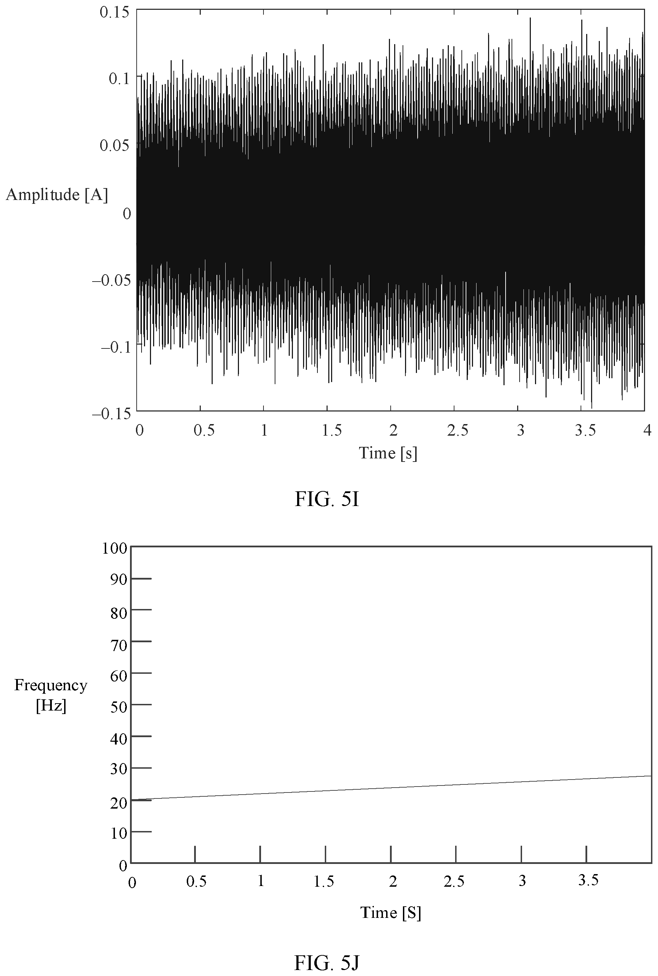

For example, FIG. 5G is a time-domain diagram of another set of current signals, with an acquisition duration of 4 seconds. Based on FIG. 5G, a time-frequency diagram of the asynchronous motor in FIG. 5H may be obtained by using a Fourier transform method. FIG. 5I is a time-domain diagram of another set of vibration signals, with an acquisition duration of 4 seconds. Based on FIG. 5I, a time-frequency diagram of the asynchronous motor in FIG. 5J may be obtained by using a Fourier transform method.

Based on FIG. 5H, the theoretical speed $v_0$ and a mean theoretical speed $\overline{v}_0$ of the asynchronous motor may be obtained, where the mean theoretical speed is $\overline{v}_0$ = mean($v_0$). Based on FIG. 5J, the actual speed $v_1$ of the motor may be obtained. A theoretical acceleration $a_0$ and an actual acceleration $a_1$ of the asynchronous motor may be obtained by separately calculating first-order differences of the theoretical speed $v_0$ and the actual speed $v_1$ of the asynchronous motor, where the theoretical acceleration is $a_0$ = $v_0$/$\Delta t$, the actual acceleration is $a_1$ = $v_1$/$\Delta t$, and t is the sampling duration of the current signals in FIG. 5G and the vibration signals in FIG. 5I. Then, according to the equivalent acceleration ratio being equal to a ratio between the actual acceleration of the asynchronous motor and the theoretical acceleration sent by the controller of the asynchronous motor, the equivalent acceleration ratio of the asynchronous motor may be obtained as $r_a$=$a_1$/$a_0$.

S480: Calculate a mean square value of the vibration signals, and use the mean square value as a torque.

In a possible implementation, the torque may be obtained by obtaining a torque signal z(t) acquired by a torque sensor, where t is a sampling duration.

In another possible implementation, the torque may be obtained by calculating the mean square value of the vibration signals of the asynchronous motor.

S490: Calculate distribution proportions of the equivalent slip, the equivalent speed ratio, and the equivalent acceleration ratio of the data in the training dataset in each distribution area within a preset confidence range.

In a possible implementation, data of the equivalent slip, the equivalent speed ratio, and the equivalent acceleration ratio of each of the training dataset and the test dataset of the asynchronous motor may be divided into a plurality of distribution areas based on a speed level, the torque, the theoretical speed in the steady state, and the mean theoretical speed in the non-steady state of the asynchronous motor. For example, each distribution area of the equivalent slip of the training dataset of the asynchronous motor has a same theoretical speed or mean theoretical speed, a same speed level, and a same torque. Alternatively, each distribution area of the equivalent slip of the training dataset of the asynchronous motor has a same theoretical speed or mean theoretical speed, and a same torque. Alternatively, each distribution area of the equivalent slip of the training dataset of the asynchronous motor has a same speed level and a same torque.

It can be understood that a division principle of the distribution areas is that the data of the three characteristic parameters, namely, the equivalent slip, the equivalent speed ratio, and the equivalent acceleration ratio, in the training dataset and the test dataset of the asynchronous motor is divided based on a same operating scenario, and a same distribution area is a same operating scenario. In this way, a working status of the asynchronous motor can be assessed in the same operating scenario. In embodiments of this application, the division principle of the distribution areas of the asynchronous motor is not specifically limited.

In a possible implementation, the division of the distribution areas is based on the same theoretical speed or mean theoretical speed, the same speed level, and the same torque. Assuming that the torque of the asynchronous motor is z(t), and the speed level is i, which is a natural number, a torque parameter may be denoted as $z_i$, and a set of torque in a sampling duration is $z_i$ = mean(z(t)), where mean($\cdot$) represents an average operation.

In this case, in a steady state, in a distribution area with the theoretical speed $v_0$ and the torque $z_i$, the equivalent slip of the asynchronous motor corresponding to the current signals in FIG. 5A and the vibration signals in FIG. 5D may be denoted as $\varepsilon_v|_{v0,zi}$=1.70 Hz, the equivalent speed ratio of the asynchronous motor is $r_v|_{v0,z_i}$, and the equivalent acceleration ratio of the asynchronous motor is $r_a|_{v0,zi}$.

In a non-steady state, in a distribution area with the mean theoretical speed $v_0$ and the torque $z_i$, the equivalent acceleration ratio of the asynchronous motor corresponding to the current signals in FIG. 5G and the vibration signals in FIG. 5I is $r_a|_{v0,z_i}$.

It can be understood that, a distribution center of each distribution area may be obtained based on a plurality of respective distribution areas of the equivalent slip, the equivalent speed ratio, and the equivalent acceleration ratio.

For example, a distribution center of a distribution area of the equivalent slip of the data in the training dataset may be denoted as $c\varepsilon_k|_{v_0,z_i}$, a distribution center of a distribution area of the equivalent speed ratio of the data in the training dataset may be denoted as $cv_k|_{v_0,z_i}$, and a distribution center of a distribution area of the equivalent acceleration ratio of the data in the training dataset may be denoted as $ca_k|_{v_0,zi}$, where k represents a sequence number of the distribution area, and k is a natural number.

Because the equivalent slip, the equivalent speed ratio, and the equivalent acceleration ratio follow a normal distribution, the preset confidence range may be set to any one of [-3σ, 3σ], [-2σ, 2σ], or [-σ, σ], where σ is a standard deviation of the characteristic parameters, for example, the equivalent slip, the equivalent speed ratio, and the equivalent acceleration ratio. Distribution proportions of sample quantities of distances of data in the respective distribution areas of the equivalent slip, the equivalent speed ratio, and the equivalent acceleration ratio of the data in the training dataset from the distribution centers of the distribution areas with the preset confidence range in total sample quantities of the data in the distribution areas may be separately calculated.

A distribution proportion of a sample quantity of a distance of data in each distribution area of the equivalent slip of the data in the training dataset from a distribution center of the distribution area within the preset confidence range in the total sample quantity may be denoted as $\omega\varepsilon_k|_{v_0,zi}$. A distribution proportion of a sample quantity of a distance of data in each distribution area of the equivalent speed ratio of the data in the training dataset from a distribution center of the distribution area within the preset confidence range in the total sample quantity may be denoted as $\omega v_k|_{v_0,zi}$. A distribution proportion of a sample quantity of a distance of data in each distribution area of the equivalent acceleration ratio of the data in the training dataset from a distribution center of the distribution area within the preset confidence range in the total sample quantity may be denoted as $\omega a_k|_{v_0,zi}$.

S500: Calculate distribution proportions of the equivalent slip, the equivalent speed ratio, and the equivalent acceleration ratio of the data in the test dataset in each distribution area within the preset confidence range.

It can be understood that a method similar to step S490 may be used. A distribution center of a distribution area of the equivalent slip of the data in the test dataset may be denoted as $\widehat{c\varepsilon}_k|_{v_0,z_i}$, a distribution center of a distribution area of the equivalent speed ratio of the data in the test dataset may be denoted as $\widehat{cv}_k|_{v_0,z_i}$, and a distribution center of a distribution area of the equivalent acceleration ratio of the data in the test dataset may be denoted as $\widehat{ca}_k|_{v_0,z_i}$, where $k$ represents a sequence number of the distribution center, and $k$ is a natural number.

In addition, the same preset confidence range as in the training dataset may be obtained. A distribution proportion of a sample quantity of a distance of data in each distribution area of the equivalent slip of the data in the test dataset from a distribution center of the distribution area within the preset confidence range in the total sample quantity of the data in the distribution area is calculated as $\widehat{\omega\varepsilon}_k|_{v_0,z_i}$. A distribution proportion of a sample quantity of a distance of data in each distribution area of the equivalent speed ratio of the data in the test dataset from a distribution center of the distribution area within the preset confidence range in the total sample quantity of the data in the distribution area is calculated as $\widehat{\omega v}_k|_{v_0,z_i}$. A distribution proportion of a sample quantity of a distance of data in each distribution area of the equivalent acceleration ratio of the data in the test dataset from a distribution center of the distribution area within the preset confidence range in the total sample quantity of the data in the distribution area is calculated as $\widehat{\omega a}_k|_{v_0,z_i}$.

S510: Calculate a health state corresponding to the test dataset.

Specifically, a distribution difference between equivalent slips of the training dataset and the test dataset in each distribution area, that is, a distance between two distribution centers $\Delta c\varepsilon_k|_{v_0,z_i} = \widehat{c\varepsilon}_k|_{v_0,z_i} - c\varepsilon_k|_{v_0,z_i}$, a distribution difference between equivalent speed ratios of the training dataset and the test dataset in each distribution area, that is, a distance between two distribution centers $\partial cv_k|_{v_0,z_i} = \widehat{cv}_k|_{v_0,z_i}/cv_k|_{v_0,z_i}$, and a distribution difference between equivalent acceleration ratios of the training dataset and the test dataset in each distribution area, that is, a distance between two distribution centers $\partial ca_k|_{v_0,z_i} = \widehat{ca}_k|_{v_0,z_i}/ca_k|_{v_0,z_i}$, may be calculated based on the results in step S490 and step S500.

Then, the statistical difference between the equivalent slips of the training dataset and the test dataset in all of the distribution areas, the statistical difference between the equivalent speed ratios of the training dataset and the test dataset in all of the distribution areas, and the statistical difference between the equivalent acceleration ratios of the training dataset and the test dataset in all of the distribution areas are calculated.

The statistical difference between the equivalent slips of the training dataset and the test dataset in all of the

distribution areas is:

$$\bar{\varepsilon} = \sum_{k=1}^{kmax}(\Delta c\varepsilon_k|_{v_0,z_i} * \widehat{\omega\varepsilon}_k|_{v_0,z_i}) \tag{1}$$

The statistical difference between the equivalent speed ratios of the training dataset and the test dataset in all of the distribution areas is:

$$\bar{r}_v = \sum_{k=1}^{kmax}(\partial cv_k|_{v_0,z_i} * \widehat{\omega v}_k|_{v_0,z_i}) \tag{2}$$

The statistical difference between the equivalent acceleration ratios of the training dataset and the test dataset in all of the distribution areas is:

$$\bar{r}_a = \sum_{k=1}^{kmax}(\partial ca_k|_{v_0,z_i} * \widehat{\omega a}_k|_{v_0,z_i}) \tag{3}$$

Then, the results are substituted into a health state formula, to obtain the health state of the asynchronous motor corresponding to the test dataset.

$$score = (\omega_v \bar{r}_v + \omega_a \bar{r}_a)/\sum_{k=1}^{kmax}\omega_k \tag{4}$$

where the health state is denoted as *score*, $\omega_v$ and $\omega_a$ are weight coefficients of the equivalent speed ratio and the equivalent acceleration ratio, and $\omega_v + \omega_a = 1$. $\omega_v$, $\omega_a$ may be adjusted according to the actual use. For example, it is set that $\omega_v = \omega_a = 0.5$. $\omega_k$ is a weight coefficient of the equivalent slip, and generally, $\omega_k = \frac{v_0 - c\varepsilon_k|_{v_0,z_i}}{v_0 - \widehat{c\varepsilon}_k|_{v_0,z_i}}$. $\omega_k = \frac{\lambda_k(v_0 - c_k|_{v_0,z_i})}{v0 - \widehat{c\varepsilon}_k|_{v_0,z_i}}$

may also be adjusted according to the actual situation, and it needs to be met that $\sum_{k=1}^{kmax}\lambda_k = 1$. In embodiments of this application, specific numerical values of the weight coefficients of the equivalent speed ratio and the equivalent acceleration ratio and $\lambda_k$ are not specifically limited.

It can be understood that, the following may be set: When the health state is greater than or equal to 0.85, the health status of the asynchronous motor is assessed as good; when the health state is less than 85 and greater than or equal to 0.60, the health status of the asynchronous motor is assessed as needing monitoring; and when the health state is less than 60, the health status of the asynchronous motor is assessed as poor, meaning that a fault occurs and repair is needed. In embodiments of this application, the setting described above is not specifically limited.

S520: Create an archive based on the distribution area, the equivalent slip, the equivalent speed ratio, the equivalent acceleration ratio, and the health state.

In the above-described health state assessment method, the characteristic parameters that correspond to the training dataset and the test dataset and that are used to represent the speed status of the asynchronous motor are separately calculated. For example, the characteristic parameters may include the equivalent slip, the equivalent speed ratio, and the equivalent acceleration ratio. Then, the characteristic parameters of the training dataset and the test dataset in each of the distribution areas are compared, to obtain the distribution differences between the characteristic parameters of the training dataset and the test dataset in each distribution area, and the statistical differences between the characteristic parameters of the training dataset and the test dataset in all of the distribution areas. Finally, the specific numerical value of the health state of the asynchronous motor corresponding to the test dataset is obtained based on the statistical differences between the characteristic parameters of the training dataset and the test dataset in all of the distribution areas and the weight of each characteristic parameter.

It can be understood that any type of fault of the asynchronous motor may directly cause an output status of the asynchronous motor to change, thereby affecting the normal use of the asynchronous motor. Therefore, the above-described health state assessment method allows for a relatively accurate assessment of the health state of the real-time operational state of the asynchronous motor by comparing the distribution differences between the characteristic parameters of the output status of the asynchronous motor in the healthy operational state that correspond to the training dataset with the characteristic parameters of the output status of the asynchronous motor in the real-time operational state that correspond to the test dataset. In addition, a comparison between the speed characteristic parameters of the asynchronous motor allows for a relatively accurate comparison result between the real-time health status and the healthy operational state of the asynchronous motor, even when the application scenarios are not comprehensive or the amount of data is insufficient.

In addition, the parameters are stored into different archives, which can also provide accurate and rich reference basis for the subsequent life prediction, degradation prediction, and the like of the asynchronous motor.

For example, an electronic device 100 may include but is not limited to user equipment (user equipment, UE), a terminal (terminal), or the like. For example, the electronic device may be a tablet computer (portable Android device, PAD), a personal digital assistant (personal digital assistant, PDA), a handheld device with a wireless communication function, a computing device, a vehicle-mounted device, or a wearable device; or may be a mobile terminal or a fixed terminal, for example, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home). A form of the terminal device is not specifically limited in embodiments of this application.

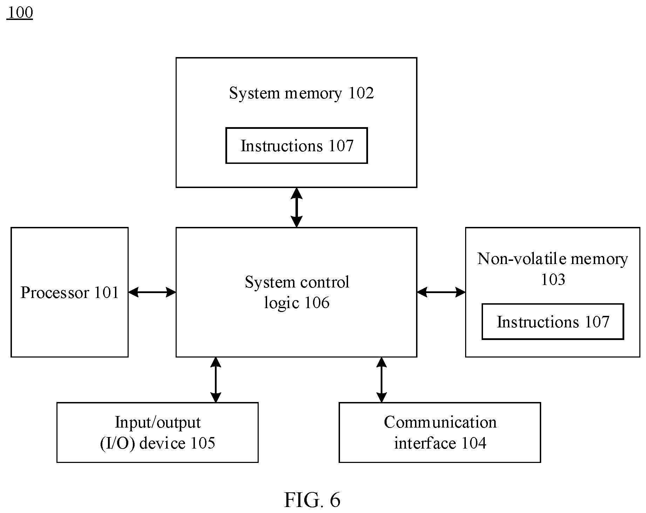

A hardware structure of the electronic device 100 in an embodiment of this application is described below with reference to FIG. 6.

FIG. 6 is a diagram of a hardware structure of an electronic device 100 according to some embodiments of this application. As shown in FIG. 6, the electronic device 100 includes one or more processors 101, a system memory 102, a non-volatile memory (non-volatile memory, NVM) 103, a communication interface 104, an input/output (I/O) device 105, and a system control logic 106 configured to couple the processor 101, the system memory 102, the non-volatile memory 103, the communication interface 104, and the input/output (I/O) device 105.

The processor 101 may include one or more processing units, for example, may include a central processing unit (central processing unit, CPU), an application processor (application processor, AP), a modem processor, a graphics processing unit (graphics processing unit, GPU), an image signal processor (image signal processor, ISP), a digital signal processor (digital signal processor, DSP), a neural network processor (neural network processing unit, NPU), a microprocessor (micro-programmed control unit, MCU), a baseband processor, an artificial intelligence (artificial intelligence, AI) processor, a processing module or a processing circuit of a programming logic device (field programmable gate array, FPGA), or another processor that includes the image processing apparatus in this application and implements the above-described image processing method, where different processing units may be independent devices, or may be integrated into one or more processors. There is no specific requirement for the processor type. The processor 101 may be configured to perform the health state assessment method according to an embodiment of this application.

The system memory 102 is a volatile memory, for example, a random-access memory (random-access memory, RAM) or a double data rate synchronous dynamic random-access memory (double data rate synchronous dynamic random access memory, DDR SDRAM). The system memory is configured to temporarily store data and/or instructions.

The non-volatile memory 103 may include one or more tangible and non-transitory computer-readable media for storing data and/or instructions. In some embodiments, the non-volatile memory 103 may include any suitable non-volatile memory such as a flash memory and/or any suitable non-volatile storage device such as a hard disk drive (hard disk drive, HDD), a compact disc (compact disc, CD), a digital versatile disc (digital versatile disc, DVD), or a solid-state drive (solid-state drive, SSD). In some embodiments, the non-volatile memory 103 may alternatively be a removable storage medium, for example, a secure digital (secure digital, SD) storage card.

In particular, the system memory 102 and the non-volatile memory 103 may respectively include a temporary copy and a permanent copy of instructions 107. The instructions 107 may be executed by at least one of the processors 101 to cause the electronic device 100 to implement the model detection method provided in the embodiments of this application.

In some embodiments, the processor 101 may invoke and execute the executable instructions for model detection provided in the embodiments of this application and stored in the system memory 102 and the non-volatile memory 103, to implement the health state assessment method provided in the embodiments of this application.

The communication interface 104 may include a transceiver for providing a wired or wireless communication interface for the electronic device 100, to communicate with any other suitable device via one or more networks. In some embodiments, the communication interface 104 may be integrated into another component of the electronic device 100. For example, the communication interface 104 may be integrated into the processor 101. In some embodiments, the electronic device 100 may communicate with another device through the communication interface 104.

The communication interface 104 may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

The MIPI interface may be configured to connect the processor 101 to a peripheral component, for example, a display or a camera. The MIPI interface includes a camera serial interface (camera serial interface, CSI), a display serial interface (display serial interface, DSI), and the like. In some embodiments, the processor 101 communicates with the camera through the CSI interface, to implement a shooting function of the electronic device 100. The processor 101 communicates with the display through the DSI interface, to implement a display function of the electronic device 100.

The GPIO interface may be configured by software. The GPIO interface may be configured as a control signal or a data signal. In some embodiments, the GPIO interface may be configured to connect the processor 110 to the camera, the display, the wireless communication module, the audio module, the sensor module, or the like. The GPIO interface may alternatively be configured as an I2C interface, an I2S interface, a UART interface, an MIPI interface, or the like.

The USB interface is an interface that conforms to a USB standard specification, and may be specifically a mini USB interface, a micro USB interface, a USB type-C interface, or the like. The USB interface may be configured to connect to a charger for charging the electronic device 100, and may be configured to transmit data between the electronic device 100 and a peripheral device. The interface may be further configured to connect another electronic device.

It can be understood that an interface connection relationship between modules illustrated in embodiments of this application is merely an illustrative description, and does not constitute a limitation on a structure of the electronic device 100. In some other embodiments of this application, the electronic device 100 may alternatively use an interface connection manner different from that in the above-described embodiment, or use a combination of a plurality of interface connection manners.

The input/output (I/O) device 105 may include an input device such as a keyboard or a mouse, and an output device such as a display. A user may interact with the electronic device 100 by using the input/output (I/O) device 105.

The system control logic 106 may include any suitable interface controller, to provide any suitable interface for another module of the terminal 100. For example, in some embodiments, the system control logic 106 may include one or more memory controllers, to provide an interface connected to the system memory 102 and the non-volatile memory 103.

In some embodiments, at least one of the processors 101 may be packaged together with logic of one or more controllers used for the system control logic 106, to form a system in package (System in Package, SiP). In some other embodiments, at least one of the processors 101 may be integrated on a same chip with logic of one or more controllers used for the system control logic 106, to form a system-on-chip (System-on-Chip, SoC). The system control logic 106 may generate an operation control signal based on instruction operation code and a timing signal, to complete control of instruction fetching and instruction execution.

Although not shown in FIG. 6, the electronic device 100 may further include a Bluetooth device, an interface for external memory connecting an external memory card, a near-field communication (near field communication, NFC) device, and the like. Details are not described herein.

It can be understood that the structure of the electronic device 100 shown in FIG. 6 is merely an example. In some other embodiments, the electronic device 100 may include more or fewer components than those shown in the figure, or some components may be combined, or some components may be split, or different component arrangements may be used. The components shown in the figure may be implemented by hardware, software, or a combination of software and hardware.

In the foregoing embodiments, descriptions of each embodiment have respective focuses. For a part that is not described in detail or recorded in an embodiment, refer to related descriptions in other embodiments.

It is apparent to a person skilled in the art that some of the specific details presented above with respect to the electronic device 100 may not be required to practice a particular implementation or its equivalent. Similarly, another electronic device may include more subsystems, modules, components, and the like. In an appropriate case, some submodules may be implemented as software or hardware. Therefore, it should be understood that the foregoing descriptions are not intended to be exhaustive or to limit the present disclosure to the precise form described herein. On the contrary, it is apparent to those of ordinary skill in the art that many modifications and variations are possible according to the above teachings.

Embodiments disclosed in this application may be implemented in hardware, software, firmware, or a combination of these implementation methods. Embodiments of this application may be implemented as a computer program or program code executed in a programmable system. The programmable system includes at least one processor, a storage system (including a volatile memory, a non-volatile memory, and/or a storage element), at least one input device, and at least one output device.

The program code may be applied to input instructions, to perform functions described in this application and generate output information. The output information may be applied to one or more output devices in a known manner. For a purpose of this application, a processing system includes any system having a processor such as a digital signal processor (DSP), a microcontroller, an application-specific integrated circuit (ASIC), or a microprocessor.

The program code may be implemented by using a high-level programming language or an object-oriented programming language, to communicate with the processing system. The program code may alternatively be implemented in an assembly language or a machine language when required. Actually, the mechanism described in this application is not limited to a scope of any particular programming language. In any case, the language may be a compiled language or an interpretive language.

In some cases, the disclosed embodiments may be implemented in hardware, firmware, software, or any combination thereof. The disclosed embodiments may alternatively be implemented as instructions that are carried or stored on one or more transitory or non-transitory machine-readable (for example, computer-readable) storage media and that may be read and executed by one or more processors. For example, the instructions may be distributed over a network or through another computer-readable medium. Therefore, the machine-readable medium may include any mechanism for storing or transmitting information in a machine (for example, computer)-readable form. The machine-readable medium includes but is not limited to a floppy disk, a compact disc, an optical disc, a magneto-optical disc, a read-only memory (read-only memory, ROM), a random-access memory (random access memory, RAM), an erasable programmable read-only memory (erasable programmable read-only memory, EPROM), an electrically erasable programmable read-only memory (electrically erasable programmable read-only memory, EEPROM), a magnetic card, an optical card, a flash memory, or a tangible machine-readable memory used to transmit information (for example, a carrier, an infrared signal, or a digital signal) by using a propagating signal in an electrical, optical, acoustic, or another form over the internet. Therefore, the machine-readable medium includes any type of machine-readable medium suitable for storing or transmitting an electronic instruction or information in a machine (namely, computer)-readable form.

In the accompanying drawings, some structural or method features may be shown in a particular arrangement and/or order. However, it should be understood that such a specific arrangement and/or sequence may not be required. In some embodiments, these features may be arranged in a manner and/or order different from those/that shown in the descriptive accompanying drawings. In addition, inclusion of the structural or method features in a particular figure does not imply that such features are needed in all embodiments, and in some embodiments, these features may not be included or may be combined with other features.

It should be noted that all units/modules mentioned in device embodiments of this application are logical units/modules. Physically, one logical unit/module may be one physical unit/module, may be a part of one physical unit/module, or may be implemented by using a combination of a plurality of physical units/modules. Physical implementations of these logical units/modules are not the most important, and a combination of functions implemented by these logical units/modules is a key to resolve the technical problem provided in this application. In addition, to highlight an innovative part of this application, a unit/module that is not closely related to resolving the technical problem provided in this application is not introduced in the foregoing device embodiments of this application. This does not mean that there are no other units/modules in the foregoing device embodiments.

It should be noted that: In the examples and specification of this application, relational terms such as first and second are merely used to distinguish one entity or operation from another, and do not necessarily require or imply any such actual relationship or order between these entities or operations. Moreover, the terms "include" or any other variant thereof is intended to cover a non-exclusive inclusion, so that a process, a method, an article, or a device that includes a list of elements not only includes those elements but also includes other elements that are not expressly listed, or further includes elements inherent to such a process, method, article, or device. An element preceded by "includes a ..." does not, without more constraints, preclude the existence of additional identical elements in the process, method, article, or device that includes the element.

Although this application has been illustrated and described with reference to some preferred embodiments of this application, a person of ordinary skill in the art should understand that various changes may be made to this application in terms of form and details without departing from the scope of this application.

## Claims

1. A health state assessment method, applied to an electronic device, and comprising:

   obtaining first speed characteristic parameters of a motor in a first duration; and
   determining a health state of the motor in the first duration based on differences between the first speed characteristic parameters and standard speed characteristic parameters.

2. The method according to claim 1, wherein the first speed characteristic parameters comprise an equivalent slip in the first duration, an equivalent speed ratio in the first duration, and an equivalent acceleration ratio in the first duration; the standard speed characteristic parameters comprise an equivalent slip in a second duration, an equivalent speed ratio in the second duration, and an equivalent acceleration ratio in the second duration; and the second duration is any duration when the motor is in a healthy operational state.

3. The method according to claim 2, wherein

   the equivalent slip is determined based on a difference between an actual speed of the motor and a theoretical speed of the motor in a first case;

the equivalent speed ratio is determined based on a ratio between the actual speed of the motor and the theoretical speed of the motor in the first case; and

the equivalent acceleration ratio is determined based on a ratio between an actual acceleration of the motor and a theoretical acceleration sent by a controller of the motor in a second case, wherein

the first case comprises a case in which the theoretical speed of the motor and the actual speed of the motor are constant values, and the second case comprises a case in which neither of the theoretical speed of the motor and the actual speed of the motor is a constant value.

4. The method according to claim 1, wherein determining the health state of the motor in the first duration based on the differences between the first speed characteristic parameters and the standard speed characteristic parameters comprises:

obtaining distribution differences between the first speed characteristic parameters and the standard speed characteristic parameters in various operating scenarios;

obtaining distribution proportions of data of the first speed characteristic parameters in each operating scenario within a first confidence range in data of the first speed characteristic parameters in all of the operating scenarios; and

obtaining the health state of the motor in the first duration based on the distribution differences and the distribution proportions, wherein

each of the operating scenarios is a scenario in a same operating condition.

5. The method according to claim 4, wherein the same operating condition comprises:

having a same theoretical speed or a same mean theoretical speed, a same speed level, and a same torque;

having a same theoretical speed or a same mean theoretical speed, and a same torque; or

having a same speed level and a same torque.

6. The method according to claim 4, wherein obtaining the distribution differences between the first speed characteristic parameters and the standard speed characteristic parameters in the various operating scenarios comprises:

obtaining a distribution center of an equivalent slip in the first duration, a distribution center of an equivalent speed ratio in the first duration, and a distribution center of an equivalent acceleration ratio in the first duration that correspond to the first speed characteristic parameters in each operating scenario;

obtaining a distribution center of an equivalent slip in the second duration, a distribution center of an equivalent speed ratio in the second duration, and a distribution center of an equivalent acceleration ratio in the second duration that correspond to the standard speed characteristic parameters in each operating scenario;

obtaining a first distance between the distribution center of the equivalent slip in the first duration and the distribution center of the equivalent slip in the second duration in each operating scenario;

obtaining a second distance between the distribution center of the equivalent speed ratio in the first duration and the distribution center of the equivalent speed ratio in the second duration in each operating scenario; and

obtaining a third distance between the distribution center of the equivalent acceleration ratio in the first duration and the distribution center of the equivalent acceleration ratio in the second duration in each operating scenario.

7. The method according to claim 6, wherein obtaining the distribution proportions of the data of the first speed characteristic parameters in each operating scenario within the first confidence range in the data of the first speed characteristic parameters in all of the operating scenarios comprises:

obtaining a first proportion of a sample quantity, within the first confidence range, of a distance that is from the distribution center of the operating scenario and that is for data of the equivalent slip in the first duration in each operating scenario, in a total sample quantity of the data of the equivalent slip in the first duration in the operating scenario;

obtaining a second proportion of a sample quantity, within the first confidence range, of a distance that is from the distribution center of the operating scenario and that is for data of the equivalent speed ratio in the first duration in each operating scenario, in a total sample quantity of the data of the equivalent speed ratio in the first duration in the operating scenario; and

obtaining a third proportion of a sample quantity, within the first confidence range, of a distance that is from the distribution center of the operating scenario and that is for data of the equivalent acceleration ratio in the first duration in each operating scenario, in a total sample quantity of the data of the equivalent acceleration ratio in the first duration in the operating scenario.

8. The method according to claim 7, wherein obtaining the health state of the motor in the first duration based on the distribution differences and the distribution proportions comprises:

obtaining, based on the first distance and the first proportion in each operating scenario, a first statistical difference between the equivalent slip in the first duration and the equivalent slip in the second duration in all of the operating scenarios;

obtaining, based on the second distance and the second proportion in each operating scenario, a second statistical difference between the equivalent speed ratio in the first duration and the equivalent speed ratio in the second duration in all of the operating scenarios;

obtaining, based on the third distance and the third proportion in each operating scenario, a third statistical difference between the equivalent acceleration ratio in the first duration and the equivalent acceleration ratio in the second duration in all of the operating scenarios; and

obtaining the health state of the motor in the first duration based on the first statistical difference, the second statistical difference, the third statistical difference, and weight coefficients respectively corresponding to the equivalent slip, the equivalent speed ratio, and the equivalent acceleration ratio.

9. The method according to claim 4, wherein the first confidence range comprises any one of $[-3\sigma, 3\sigma]$, $[-2\sigma, 2\sigma]$, or $[-\sigma, \sigma]$, wherein $\sigma$ is a standard deviation of the parameters of the first speed characteristic parameters.

10. A computer-readable storage medium, wherein the readable storage medium stores instructions that, when executed on an electronic device, cause the electronic device to implement the method according to any one of claims 1 to 9.

11. An electronic device, comprising:

a memory, configured to store instructions executable by one or more processors of the electronic device; and
a processor, which is one of the processors of the electronic device and is configured to execute the instructions stored in the memory, to implement the method according to any one of claims 1 to 9.

S101: Obtain historical operational electrical fault data of a motor under test

S102: Train a fault diagnosis model by using current signals in the historical operational electrical fault data as input data, and obtain a trained fault diagnosis model

S103: Input real-time electrical data of the motor under test into the trained fault diagnosis model, and determine whether an electrical fault occurs in the motor under test

FIG. 1A

S111: Obtain historical operational vibration fault data of a motor under test

S112: Perform feature decomposition on the historical operational vibration fault data, and obtain a fault feature library

S113: Obtain an actual vibration signal of the motor under test

S114: Match a fault feature in the actual vibration signal against the fault feature library, and determine whether a mechanical fault occurs in the motor under test

FIG. 1B

Health state assessment system

**Information acquisition module 210**

Acquire a vibration signal, a current signal, a torque signal, and the like

- Vibration signal acquisition module 211
- Current signal acquisition module 212
- Torque signal acquisition module 213
- Speed level signal acquisition module 214

**Feature calculation module 220**

Calculate a theoretical speed and other related features of an asynchronous motor

- Theoretical speed and actual speed calculation module 221
- Equivalent slip calculation module 222
- Equivalent speed ratio calculation module 223
- Equivalent acceleration ratio calculation module 224

**Health assessment module 230**

Health state assessment includes comprehensive assessment of speed levels, torque, and characteristic factors

- Speed level obtaining module 231
- Torque obtaining module 232
- Health state calculation module 233
- Health state reset module 234

**Data archive creation module 240**

Data archive creation contains a health state, characteristics for calculating the health state, the theoretical speed, the torque, and the like

- Health state archiving module 241
- Equivalent slip archiving module 242
- Equivalent acceleration ratio archiving module 243
- Equivalent speed ratio archiving module 244
- Theoretical speed and torque archiving module 245

FIG. 2

S310: Obtain a training dataset and a test dataset for health state assessment of an asynchronous motor

S320: Separately calculate characteristic parameters corresponding to the training dataset and characteristic parameters corresponding to the test dataset

S330: Calculate a health state corresponding to the test dataset, based on the characteristic parameters corresponding to the training dataset and the characteristic parameters corresponding to the test dataset

S340: Archive the characteristic parameters corresponding to the training dataset, the characteristic parameters corresponding to the test dataset, and the health state

FIG. 3

S440: Obtain a training dataset and a test dataset of vibration signals

S410: Obtain a training dataset and a test dataset of current signals

S450: Perform low-pass filtering calculation

S420: Calculate a theoretical speed

S430: Estimate an actual speed fluctuation range

S460: Calculate an actual speed

S470: Calculate an equivalent slip, an equivalent speed ratio, and an equivalent acceleration ratio

S480: Calculate a mean square value of the vibration signals, and use the mean square value as a torque

S490: Calculate distribution proportions of the equivalent slip, the equivalent speed ratio, and the equivalent acceleration ratio of data in the training dataset in each distribution area within a preset confidence range

S500: Calculate distribution proportions of the equivalent slip, the equivalent speed ratio, and the equivalent acceleration ratio of data in the test dataset in each distribution area within the preset confidence range

S510: Calculate a health state corresponding to the test dataset

S520: Create an archive based on the distribution area, the equivalent slip, the equivalent speed ratio, the equivalent acceleration ratio, and the health state

FIG. 4

FIG. 5A

FIG. 5B

FIG. 5C

FIG. 5D

FIG. 5E

FIG. 5F

FIG. 5G

FIG. 5H

FIG. 5I

FIG. 5J

100

System memory 102

Instructions 107

Processor 101

System control
logic 106

Non-volatile memory
103

Instructions 107

Input/output
(I/O) device 105

Communication
interface 104

FIG. 6

## INTERNATIONAL SEARCH REPORT

| International application No. |
| --- |
| **PCT/CN2024/103164** |

**A. CLASSIFICATION OF SUBJECT MATTER**

G01R31/34(2020.01)i

According to International Patent Classification (IPC) or to both national classification and IPC

**B. FIELDS SEARCHED**

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNABS, CNTXT, CNKI, 万方, WANFANG: 电机, 电动机, 马达, 驱动, 转速, 速度, 速率, 状态, 故障, 异常, 健康, 监测, 检测, 评估, 计算, 标准, 参考, 基准, 理论, 差, 比, 时间, 时长, 分布, 置信, 范围, 区间 VEN, USTXT, WOTXT, EPTXT: motor, drive, speed, rate, state, fault, abnormal, health, monitor, test, evaluate, calculate, standard, criteria, reference, theory, difference, ratio, time, distribute, confidence, interval, range

**C. DOCUMENTS CONSIDERED TO BE RELEVANT**

| Category* | Citation of document, with indication, where appropriate, of the relevant passages | Relevant to claim No. |
| --- | --- | --- |
| X | CN 116520296 A (BEIJING BENEWAKE INTELLIGENT EQUIPMENT CO., LTD.) 01 August 2023 (2023-08-01)<br>description, paragraphs 50-69 and 101-102, and figures 2-3 | 1, 10-11 |
| X | CN 114779077 A (CHINA FAW CO., LTD.) 22 July 2022 (2022-07-22)<br>description, paragraphs 47-58, and figure 1 | 1, 10-11 |
| A | CN 115136487 A (MITSUBISHI ELECTRIC CORP.) 30 September 2022 (2022-09-30)<br>entire document | 1-11 |
| A | CN 108181583 A (GOERTEK INC.) 19 June 2018 (2018-06-19)<br>entire document | 1-11 |
| A | CN 109118384 A (HUNAN YOULITAIKE AUTOMATIC SYSTEM CO., LTD.) 01 January 2019 (2019-01-01)<br>entire document | 1-11 |
| A | KR 102233170 B1 (HYUNDAI KEFICO CORP.) 29 March 2021 (2021-03-29)<br>entire document | 1-11 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **10 September 2024** | **15 September 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/103164**

| Patent document cited in search report | | | Publication date (day/month/year) | Patent family member(s) | | | Publication date (day/month/year) |
|---|---|---|---|---|---|---|---|
| CN | 116520296 | A | 01 August 2023 | None | | | |
| CN | 114779077 | A | 22 July 2022 | None | | | |
| CN | 115136487 | A | 30 September 2022 | WO | 2021166168 | A1 | 26 August 2021 |
| | | | | JP | WO2021166168 | A | 31 July 2022 |
| | | | | KR | 20220124249 | A | 13 September 2022 |
| | | | | VN | 90455 | A | 25 October 2022 |
| | | | | EP | 4109740 | A1 | 28 December 2022 |
| | | | | JP | 7361881 | B2 | 16 October 2023 |
| CN | 108181583 | A | 19 June 2018 | CN | 108181583 | B | 07 February 2020 |
| CN | 109118384 | A | 01 January 2019 | None | | | |
| KR | 102233170 | B1 | 29 March 2021 | None | | | |

Form PCT/ISA/210 (patent family annex) (July 2022)

**EP 4 779 333 A1**

**REFERENCES CITED IN THE DESCRIPTION**

**Patent documents cited in the description**

- CN 202311279483